(19) Europäisches Patentamt
European Patent Office
Office européen des brevets

(11) **EP 4 786 165 A1**

(12) **EUROPEAN PATENT APPLICATION**
published in accordance with Art. 153(4) EPC

(43) Date of publication:
**05.08.2026 Bulletin 2026/32**

(21) Application number: **23957750.5**

(22) Date of filing: **30.10.2023**

(51) International Patent Classification (IPC):
*B32B 17/10* (2006.01)  *B60J 1/00* (2006.01)
*H01Q 1/12* (2006.01)  *H01Q 1/32* (2006.01)
*H01Q 1/38* (2006.01)  *H05K 1/14* (2006.01)

(52) Cooperative Patent Classification (CPC):
**B32B 17/10; B60J 1/00; H01Q 1/12; H01Q 1/32;
H01Q 1/38; H05K 1/14**

(86) International application number:
**PCT/KR2023/016986**

(87) International publication number:
**WO 2025/095152 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **LG Electronics Inc.**
**Yeongdeungpo-gu**
**Seoul 07336 (KR)**

(72) Inventors:
• **CHOI, Kukheon**
**Seoul 06772 (KR)**
• **JUNG, Byungwoon**
**Seoul 06772 (KR)**
• **JUNG, Kangjae**
**Seoul 06772 (KR)**
• **LEE, Soyeon**
**Seoul 06772 (KR)**
• **KIM, Dongjin**
**Seoul 06772 (KR)**
• **KIM, Uisheon**
**Seoul 06772 (KR)**

(74) Representative: **Vossius & Partner**
**Patentanwälte Rechtsanwälte mbB**
**Siebertstraße 3**
**81675 München (DE)**

(54) **GLASS SUBSTRATE MODULE ARRANGED IN VEHICLE**

(57) This glass substrate module includes: a first glass substrate; a second glass substrate; a transparent antenna module arranged between the first glass substrate and the second glass substrate; a controller for controlling the transparent antenna module; and a connection unit for electrically connecting the transparent antenna module with the controller. The transparent antenna module includes a first antenna pattern part and a second antenna pattern part, and the connection unit constitutes a flexible printed circuit board and coaxial cables. A first region of the flexible printed circuit board may be connected to the transparent antenna module, and a third antenna pattern portion may be formed in a second region of the flexible printed circuit board.

*FIG. 7*

## Description

## Technical Field

The present disclosure relates to a glass substrate module arranged in a vehicle. Particularly, the present disclosure relates to a glass substrate module including a transparent antenna on a glass pane of a vehicle. More particularly, the present disclosure relates to a flexible printed circuit board configured to include a plurality of layers, the flexible printed circuit board being arrangeable on a glass pane of a vehicle.

## Background Art

A vehicle is capable of performing wireless communication with another vehicle, a surrounding object, an infrastructure, or a base station. In this regard, various communication services may be provided through a wireless communication system to which an LTE communication technology or a 5G communication technology applies. One portion of an LTE frequency band may be allocated in order to provide 5G communication services.

A vehicle body and a vehicle roof are formed of a metal material, thereby blocking a radio wave. Accordingly, a separate antenna structure may be arranged on the top of the vehicle body or on the vehicle roof. In addition, in a case where the antenna structure is arranged on the bottom of the vehicle body or on the vehicle roof, a portion of the vehicle body or the vehicle roof that corresponds to a region in which an antenna is arranged may be formed of a non-metal material.

However, in view of aesthetic design, the antenna structure needs to be integrally formed with the vehicle body or the vehicle roof. In this case, an exterior portion of the vehicle body or the vehicle roof may be formed of a metal material. Accordingly, a significant decrease in antenna performance may occur due to the vehicle body or the vehicle roof.

In this regard, a transparent antenna may be arranged on a glass pane corresponding to a window of the vehicle to enhance communication capacity without compromising the exterior design of the vehicle. However, antenna radiation efficiency and impedance bandwidth characteristics are attenuated as a result of an electrical loss of an antenna formed of a transparent material.

A transparent antenna and an antenna having a different type than the transparent antenna may be arranged on the glass pane of the vehicle. To this end, the transparent antenna may be designed to radiate signals in 4G/5G wireless communication frequency bands. The antenna having a different type than the transparent antenna may be formed of a film material. The antenna formed of a film material may be designed to emit signals at Wi-Fi frequency bands, including 2.4 GHz, 5 GHz, and 7 GHz.

In this regard, the antenna formed of a film material may be arranged adjacent to the transparent antenna or arranged on the same layer as the transparent antenna. Interference may occur between the antenna formed of a film material and a transparent electrode forming the transparent antenna at 2.4 GHz, which has a long wavelength in the Wi-Fi frequency band. Distortion in the shape of a beam may occur due to interference between the antenna made of a film material and the transparent electrode forming the transparent antenna.

## Disclosure of Invention

## Technical Problem

One object of the present disclosure is to reduce interference between a plurality of antennas in a glass substrate module, including a transparent antenna on a glass pane of a vehicle.

Another object of the present disclosure is to reduce interference between an antenna and a transparent antenna that are formed on a flexible printed circuit board configured to include a plurality of layers, the flexible printed circuit board being arrangeable on a glass pane of a vehicle.

A further object of the present disclosure is to prevent distortion in the shape of a beam due to interference between an antenna formed of a film material and a transparent electrode forming a transparent antenna.

Another object of the present disclosure is to arrange a transparent antenna and an antenna formed of a film material on one side region or the other region of a glass pane of a vehicle.

## Solution to Problem

To accomplish the above-mentioned objects and other related objects, according to an aspect of the present disclosure, there is provided a glass substrate module including: a first glass substrate; a second glass substrate; a transparent antenna module arranged between the first glass substrate and the second glass substrate; a control unit that controls the transparent antenna module; and a connection portion that electrically connects the transparent antenna and the control unit. The transparent antenna module includes a first antenna pattern portion and a second antenna pattern portion, and the connection portion constitutes a flexible printed circuit board and coaxial cables. A first region of the flexible printed circuit board is connected to the transparent antenna module, and a third antenna pattern portion is formed in a second region thereof.

According to an embodiment, the flexible printed circuit board may be formed to have a first region positioned between the first glass substrate and the second glass substrate and a second region positioned outside any one of the first and second glass substrates. A segment of the first region may be electrically connected to the transparent antenna module. A segment of the second region may be electrically connected to the coaxial cable. The third antenna pattern portion may be formed in another segment of the second region.

According to another aspect of the present disclosure, there is provided a flexible printed circuit board configured to include a plurality of layers, the flexible printed circuit board including: a first antenna connection portion and a second antenna connection portion connected to a first antenna pattern portion and a second antenna pattern portion, respectively, formed on a transparent flexible board positioned between a first glass substrate and a second glass substrate; a first cable connection portion connected to a first antenna connection portion in a first region of the second glass substrate; a second cable connection portion connected to a second antenna connection portion in a second region of the second glass substrate; and a third antenna pattern portion arranged in a third region of the second glass substrate.

According to an embodiment, the flexible printed circuit board may further include a first connection board portion that non-electrically connects between the first antenna connection portion and the second antenna connection portion; a second connection board portion that non-electrically connects the first antenna connection portion and the third antenna pattern portion; a third connection board portion that electrically connects the first antenna connection portion and the first cable connection portion; and a fourth connection board portion that electrically connects the second antenna connection portion and the second cable connection portion.

## Advantageous Effects of Invention

The technical effects of a glass substrate module, including a transparent antenna on a glass pane of a vehicle, and the technical effects of a flexible printed circuit board, including a plurality of layers, are described as follows.

According to the present disclosure, interference between the transparent antenna, arranged in a transparent region, and the antenna, arranged in an opaque region, can be reduced in the glass substrate module on the glass pane of the vehicle.

According to the present disclosure, a Wi-Fi antenna is arranged in a specific region of the flexible printed circuit board configured to include a plurality of layers, the flexible printed circuit board being arrangeable on the glass pane of the vehicle, thereby enabling a reduction in interference between the Wi-Fi antenna and the transparent antenna.

According to the present disclosure, the formation of the flexible printed circuit board to have a bent structure can prevent distortion in the shape of a beam due to interference between the antenna formed of a film material and a transparent electrode forming the transparent antenna.

According to the present disclosure, the transparent antenna, having a transparent electrode structure exhibiting heterogeneous surface resistance, and the opaque antenna, formed of a film material, can be arranged on one side or the other side of the glass pane of the vehicle.

The further range of potential embodiments and technical applications of the present disclosure will be readily understood or evident from the following detailed description of the present disclosure. However, it will be apparent to persons having ordinary skill in the art that various alterations and equivalent substitutions may be made within the technical ideas and scope of the present disclosure. Accordingly, the detailed description and specific embodiments, including preferred embodiments, are intended to be exemplary and not limiting.

## Brief Description of Drawings

FIG. 1 is a view illustrating a vehicle according to an embodiment of the present disclosure.
FIG. 2 is a diagram illustrating a configuration of the vehicle according to the embodiment of the present disclosure.
FIG. 3 is a perspective view illustrating a vehicular glass pane that may be assembled to or attached to a frame of a vehicle.
FIG. 4 is a cross-sectional view of the vehicular glass pane in FIG. 3 and the frame of the vehicle, which are assembled.
FIG. 5 is a view illustrating an antenna assembly and a connector structure that are arranged in a transparent region and an opaque region of a glass pane of the vehicle.
FIG. 6 is a view illustrating the structure of a glass substrate module in which a transparent antenna module according to the present disclosure, which is to be formed on the vehicular glass pane, can be arranged.
FIG. 7 is a view illustrating a structure in which the transparent antenna module is formed on a glass substrate, as illustrated in FIG. 6.
FIG. 8 is a set of views including a cross-sectional view illustrating a glass substrate module, illustrated in FIGS. 6 and 7, and a view illustrating a structure in which the glass substrate module is assembled to the vehicle.
FIG. 9 is a view illustrating a state in which a flexible printed circuit board illustrated in FIGS. 6 and 7 is partitioned on a per-region basis.
FIG. 10 is a view illustrating a structure in which the flexible printed circuit board, on which a third antenna pattern is formed, is bent.
FIGS. 11A and 11B are views showing, at 2.4 GHz and 5.7 GHz, respectively, a radiation pattern of a third antenna pattern portion designed to have a bent FPCB structure.

FIG. 12 is a graph showing the extent of isolation between each of the first and second antenna pattern portions and a third antenna pattern portion.

FIG. 13 is a set of cross-sectional views that includes a cross-sectional view illustrating a Wi-Fi antenna formed on a glass substrate and a cross-sectional view illustrating a Wi-Fi antenna formed on the flexible printed circuit board, respectively.

FIG. 14 is a set of views that includes a view illustrating a radiation pattern of the Wi-Fi antenna formed on the glass substrate and a view illustrating a radiation pattern of the Wi-Fi antenna formed on the flexible printed circuit board for comparison.

FIGS. 15 and 16 are views illustrating the flexible printed circuit board on which power feeding patterns electrically exciting the transparent antenna module according to the present disclosure are formed.

FIG. 17 is a set of views including a perspective view illustrating a structure in which the flexible circuit board of FIGS. 15 and 16 is assembled to the transparent antenna module, and a front view illustrating the structure.

FIG. 18 is a view illustrating a structure in which a conductive layer is removed from a region in which the Wi-Fi antenna of the flexible printed circuit board is formed to have a double-sided structure.

FIG. 19 is a set of views that includes a view illustrating a stack structure in which the glass substrate, including a slot layer formed to have an under-cut structure, the transparent antenna module, and the frame of the vehicle, have not yet been assembled, and an enlarged view illustrating a structure in which the assembly is complete.

FIG. 20 is a view illustrating glass substrate modules that may be arranged in a plurality of regions of the glass substrate of the vehicle.

## Mode for the Invention

Embodiments disclosed in the present specification will be described in detail below with reference to the accompanying drawings. The same reference numerals are used for the same or similar constituent elements, regardless of figure numbers, and redundant descriptions thereof are not repeated. The terms 'module' and 'unit' are hereinafter used interchangeably to name constituent elements solely for the convenience of description in the present specification. These terms are not intended to have different meanings or to indicate different functions. In addition, in describing the embodiments disclosed in the present specification, detailed descriptions of well-known related technologies may be omitted when such descriptions are deemed to obscure the nature and gist of the present disclosure. In addition, the accompanying drawings are provided solely to aid understanding of the embodiment that is disclosed in the present specification, and the technical idea that is disclosed in the present specification is not limited to the accompanying drawings. All amendments, equivalents, and substitutions that fall within the scope of the technical idea behind the present disclosure are intended to be encompassed by the accompanying drawings.

The ordinal numbers first, second, and so forth may be used to describe various elements, but they do not limit these elements. These terms are used merely to distinguish among constituent elements having similar functions.

It should be understood that a constituent element, when referred to as 'being connected to' or 'having access to' a different constituent element, may be directly connected to or have direct access to the different constituent element, or may be indirectly connected to or have access to the different constituent element through one or more intermediate constituent elements. Likewise, it should be understood that, when a constituent element is described as being 'connected to' or 'having access to' another constituent element, such connection or access may be direct without the need for one or more intermediary constituent elements.

A noun in singular form, unless clearly indicated otherwise by the context, shall be understood to include the plural form.

The terms 'include,' 'have,' and equivalent expressions, as used in the present application, shall be understood to indicate the presence of a feature, number, step, operation, constituent element, component, or combination thereof, without precluding the possibility of the presence or addition of one or more other features, numbers, steps, operations, constituent elements, components, or combinations thereof.

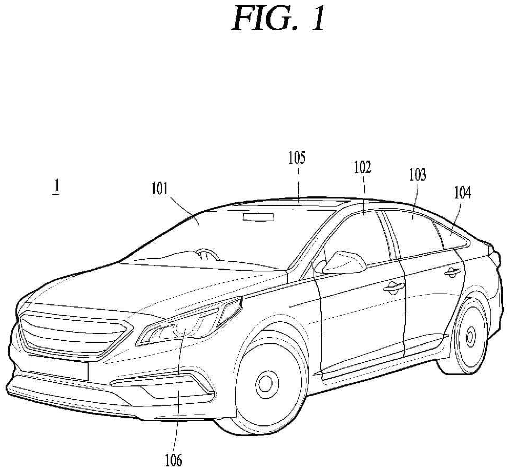

A transparent antenna module according to the present disclosure and a method of manufacturing the transparent antenna module will be described in detail below. In this regard, FIG. 1 is a view illustrating a vehicle according to an embodiment of the present disclosure.

With reference to FIG. 1, a vehicle 1 may include at least one communication antenna. The vehicle 1 may transmit and/or receive signals in various frequency bands using the communication antenna. The vehicle 1 may perform communications, such as vehicle-to-vehicle (V2V), vehicle-to-infrastructure (V2I), vehicle-to-pedestrian (V2P), and vehicle-to-network (V2N).

The antenna may be configured to include a substrate formed of a material, such as polyethylene terephthalate (PET), and an antenna pattern formed on a substrate. For example, the antenna may be a transparent antenna.

The antenna may be arranged on a dielectric member of the vehicle 1. The antenna may be arranged on a glass pane of the vehicle 1. The antenna may be coupled to or attached to a front windshield 101, a door glass pane 102 or 103, a quarter glass pane 104, a rear windshield (not illustrated), a side-view mirror (not illustrated), a sunroof 105, or a lamp glass pane 106. For example, the antenna may be a transparent antenna.

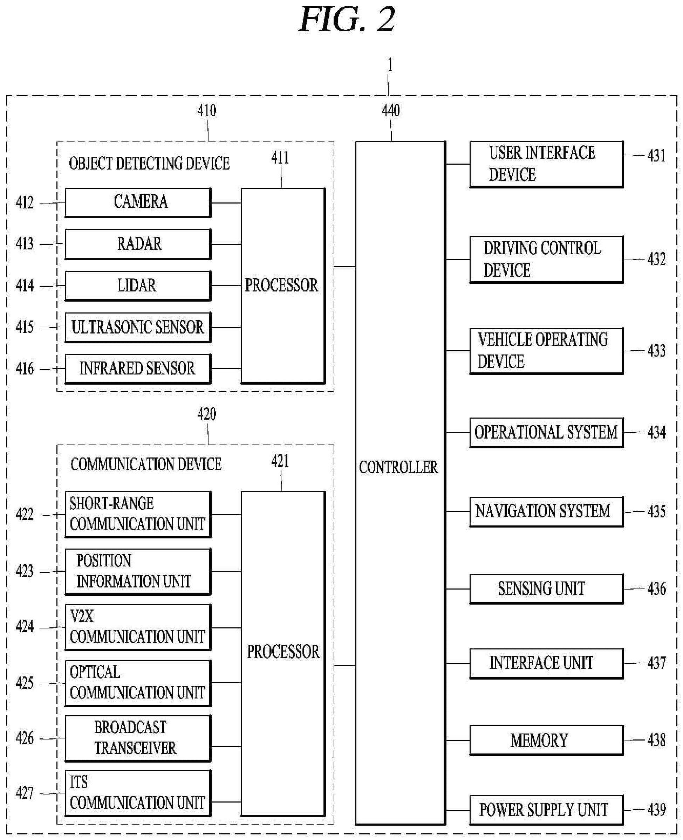

FIG. 2 is a diagram illustrating a configuration of the vehicle according to the embodiment of the present disclosure. With reference to FIG. 2, the vehicle 1 may include an object detection device 410, a communication device 420, a user interface device 431, a driving operation device 432, a vehicle driving device 433, an operational system 434, a navigation system 435, a sensing unit 436, an interface unit 437, a memory 438, a power supply unit 439, and/or a controller 440. Alternatively, the vehicle 1 may further include one or more constituent elements in addition to the above-mentioned constituent elements or may omit one or more of the above-mentioned constituent elements.

The object detection device 410 may be a device for detecting an object located outside the vehicle 1. For example, an object detection device 410 may include a processor 411, a camera 412, a radar 413, a LiDAR 414, an ultrasonic sensor 415, and/or an infrared sensor 416.

The communication device 420 may be a device for performing communication with an external device. The communication device 420 may include at least one of the following: a transmission antenna, a reception antenna, a radio frequency circuit, or an RF element. The transmission antenna and the reception antenna are used to perform communication. The radio frequency circuit and the RF element are capable of executing various communication protocols. For example, the communication device 420 may include a processor 421, a short-range communication unit 422, a position information unit 423, a V2X communication unit 424, an optical communication unit 425, a broadcast transceiver 426, and/or an ITS communication unit 427.

The user interface device 431 may be a device for enabling interaction between the vehicle 1 and a user. The vehicle 1 may implement a user interface (UI) or a user experience (UX) through the user interface device 431.

The driving operation device 432 may be a device that receives a user input for driving. The vehicle drive device 433 may be a device that electrically controls the driving of various devices within the vehicle 1. The operational system 434 may be a system that controls various operations of the vehicle 1. The navigation system 435 may provide navigation information. The sensing unit 436 may sense a state of the vehicle 1.

The interface unit 437 may function as an interface for various types of external devices that are connected to the vehicle 1. The memory 438 may store basic data regarding units of the vehicle 1, control data for operational control of the units, input and output data, and the like. The power supply unit 439 may provide the electric power necessary to operate the constituent elements. The controller 440 may control the overall operation of each unit within a vehicle 1. The controller 440 may be implemented as an electronic control unit (ECU) and/or a telematics control unit (TCU).

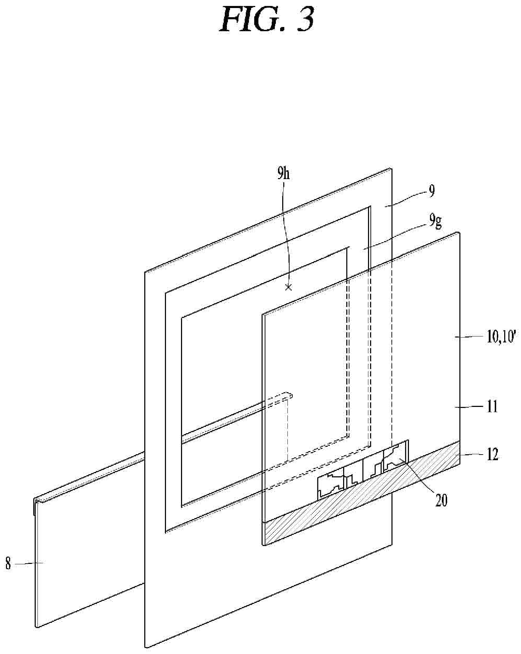

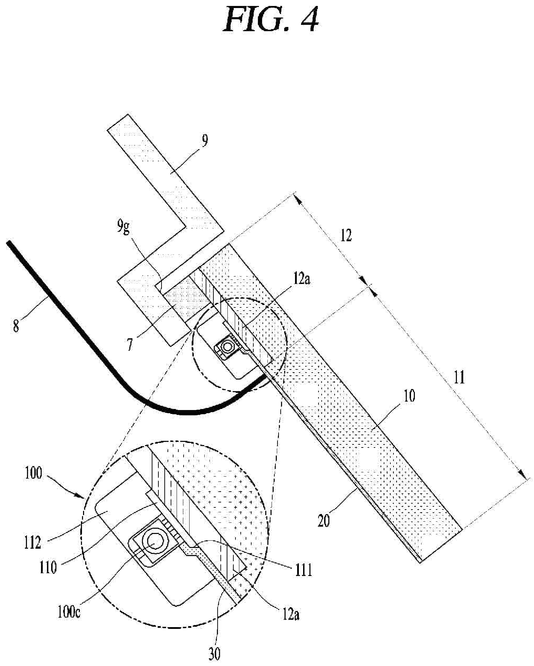

A glass pane of the vehicle may be coupled to a frame of the vehicle. The transparent antenna module according to the present disclosure is implemented on the glass pane. In this regard, FIG. 3 is a perspective view illustrating a vehicular glass pane that may be assembled to or attached to the frame of the vehicle. FIG. 4 is a cross-sectional view of the vehicular glass pane in FIG. 3 and the frame of the vehicle, which are assembled.

With reference to FIGS. 3 and 4, a glass pane 10 or 10' may be coupled to or attached to a frame 9 of the vehicle and may cover an opening 9h in the frame 9. For example, the glass pane 10 or 10' may be a glass pane of the vehicle 1, such as the front windshield 101, the door glass pane 102 or 103, the quarter glass pane 104, the rear windshield, the side-view mirror, the sunroof 105, or the lamp glass pane 106, each of which is illustrated in FIG. 1.

The groove 9g in the frame 9 may extend along an edge of the glass pane 10 or 10' and may define a boundary of the opening 9h. For example, the frame 9 may include a metallic material, and a gap between the groove 9g and the glass pane 10 or 10' may be filled with a sealant 7. The groove 9g may be formed to have a step at an internal boundary of the frame 9. A glass pane 10 on which an opaque region 12 is formed may be arranged in the groove formed to have a step at an inner end of the frame 9. Since the glass pane 10 is arranged in the groove 9g, it appears from the outside that there is no gap at the groove 9g.

The antenna 20 may be positioned on one surface of the glass pane 10 or may be positioned inside the glass pane 10. The antenna 20 may be transparent. The antenna 20 may be flexible.

A connection module 100, which includes a connector 10c, may be arranged between an edge of the glass pane 10 or 10' and the antenna 20 and may be positioned on one surface of the glass pane 10 or 10'. The connector 10c of the connection module 100 may be electrically connected to the antenna 20 through a substrate 30. An inner cover 8 may be opposite the glass plane 10 with the frame 9 in between and may cover the connection module. The inner cover 8 may be referred to as an interior cover 8. The connection module may be referred to as a connector device, a FAKRA Jack portion, or a connector assembly.

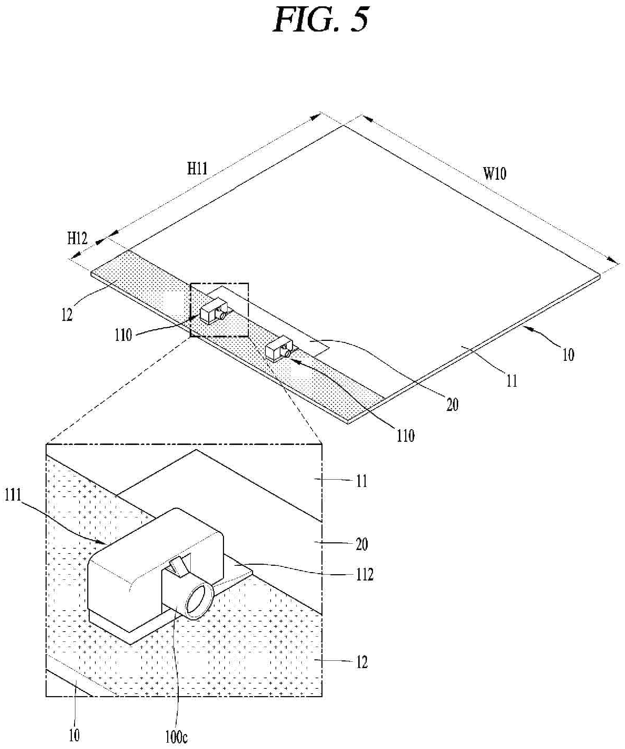

A vehicular antenna assembly in which the transparent antenna module according to the present disclosure is implemented may be arranged in a transparent region and an opaque region of the glass pane of the vehicle. In this regard, FIG. 5 is a view illustrating the antenna assembly and a connector structure that are arranged in the transparent region and the opaque region of the glass pane of the vehicle.

With reference to FIG. 5, the glass pane 10 may include a transparent region 11 and an opaque region 12. The opaque region 12 may be a black mask region or a frit region. For example, the transparent region 11 may occupy most of the glass pane 10, and the opaque region 12 may be adjacent to one edge of the glass pane 10. The transparent region 11 and the opaque region 12 may be formed to have an identical width W10, and the height H11 of the transparent region 11 may be greater than the height H12 of the opaque region 12.

The antenna 20 may be positioned on the transparent region 11 in a manner that is adjacent to a boundary between the transparent region 11 and the opaque region 12. The connection module, including the connector 100c, may be arranged on the opaque region 12, and the connector 10c of the connection module may be connected to the antenna 20 through a housing lower plate 111. The housing lower plate 111 is fastened to a housing upper plate 112 and may constitute a housing 110. The connector 100c may be accommodated inside the housing 110. The housing 110 accommodating the connector 100c may be arranged in the opaque region 12. At least one portion of the connection module may also be positioned in the transparent region 11.

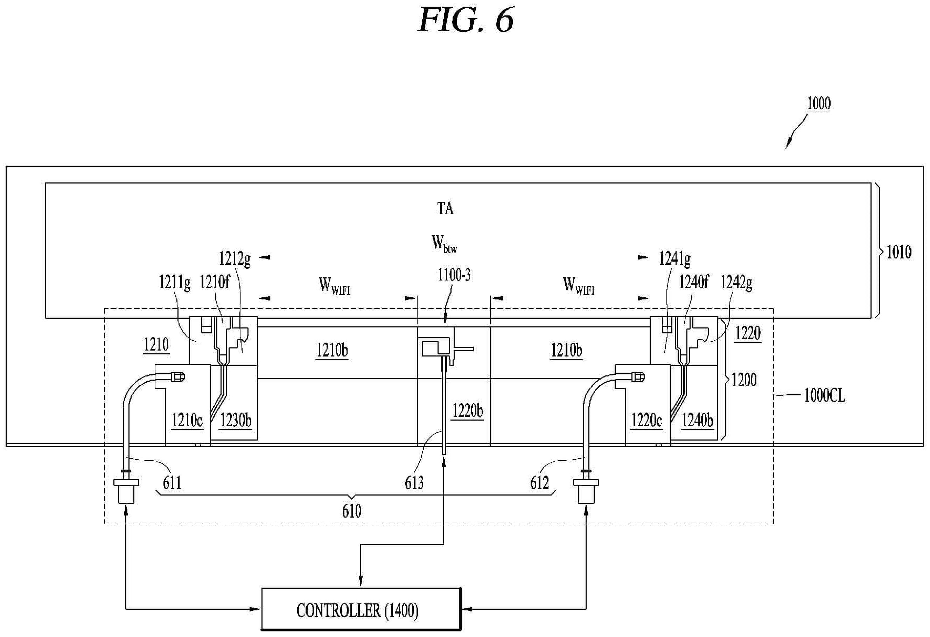

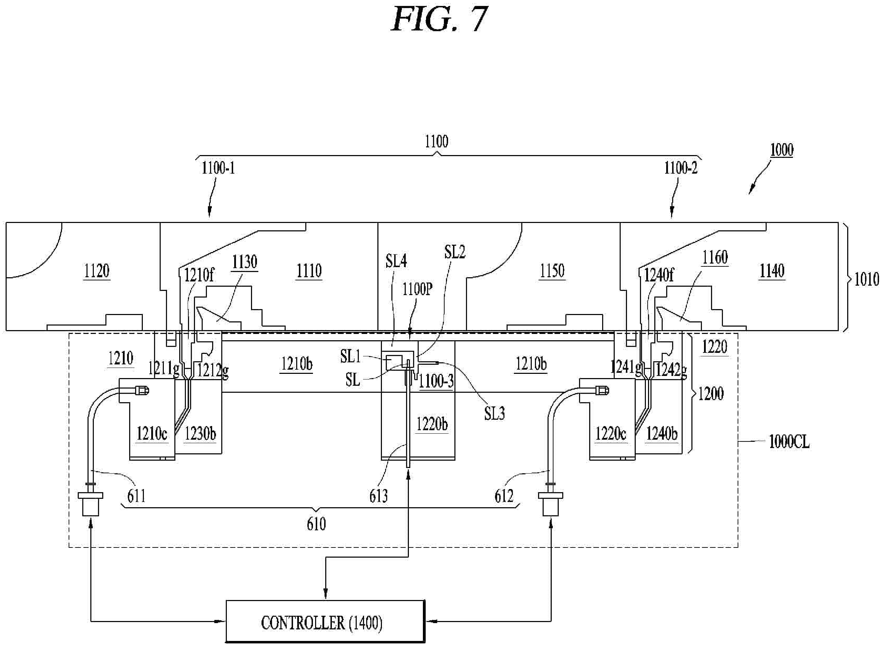

A glass substrate module, in which the transparent antenna module according to the present disclosure, which is to be formed on the vehicular glass pane, is arranged, may be arranged in the transparent region and the opaque region. In this regard, FIG. 6 is a view illustrating a structure of the glass substrate module in which the transparent antenna module according to the present disclosure, which is to be formed on the vehicular glass pane, can be arranged. FIG. 7 is a view illustrating a structure in which the transparent antenna module is formed on the glass substrate, as illustrated in FIG. 6. Specifically, FIG. 7 illustrates the structure of the glass substrate module in which the transparent antenna module, including first to third antenna pattern portions, is arranged.

With reference to FIGS. 6 and 7, a glass substrate module 1000 may include a glass substrate 1010 and a transparent antenna module 1100. The transparent antenna module 1100 may include a first antenna pattern portion 1100-1 and a second antenna pattern portion 1100-2. The glass substrate module 1000 may further include a controller 1400 and a connection portion 1000CL.

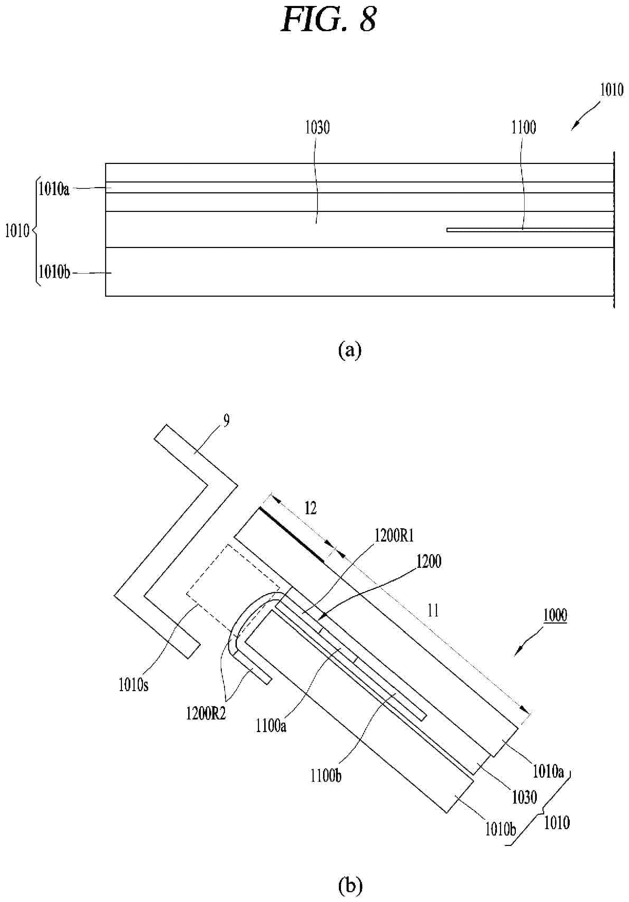

FIG. 8 is a set of views including a cross-sectional view illustrating the glass substrate module, illustrated in FIGS. 6 and 7, and a view illustrating a structure in which the glass substrate module is assembled to the frame of the vehicle. (a) of FIG. 8 is the cross-sectional view illustrating the glass substrate module illustrated in FIGS. 6 and 7. (b) of FIG. 8 is the view illustrating the structure in which the glass substrate module, illustrated in FIGS. 6 and 7, is assembled to the frame of the vehicle.

With reference to FIG. 8, the glass substrate 1010 may be formed to have a dual-interface glass structure. In this regard, the glass substrate 1010 may be formed to have a multi-layer glass substrate structure in such a manner as to include a first glass substrate 1010a and a second glass substrate 1010b.

The transparent antenna module 1100 may be arranged between the first glass substrate 1010a and the second glass substrate 1010b. The first glass substrate 1010a and the second glass substrate 1010b may be formed of laminated glass, but without being limited thereto, may vary according to the application. The first glass pane 1010a and the second glass pane 1010b may form the dual-interface glass structure by being bonded with a film layer 1030. The film layer 1030 may be formed as a polyvinyl butyral (PVB) layer, and without being limited thereto, and may vary according to the application.

With reference to (b) of FIG. 8, the glass substrate module 1000 may be coupled to or attached to the frame 9 of the vehicle. The frame 9 of the vehicle may be formed of a metal material. The glass substrate 1010 of the glass substrate module 1000 may be configured to include the first glass substrate 1010a, the second glass substrate 1010b, and the film layer 1030. The glass substrate 1010 may include the transparent region 11 and the opaque region 12. The opaque region 12 may be a black mask region or a frit region.

The opaque region 12 may be formed on the first glass substrate 1010a. The frame 9 of the vehicle can be extended in a manner that corresponds to the opaque region 12. In this regard, radio wave interference may occur between the frame 9 of the vehicle, the frame 9 being formed of a metal material, and a flexible printed circuit board 1200 on which a power feeding pattern is formed. A signal applied to the transparent antenna module by the power feeding pattern on the flexible printed circuit board 1200 may undergo radio wave interference by the frame 9 of the vehicle, the frame 9 being formed of a metal material. Specifically, since a signal in a low band (LB) undergoes interference by the frame 9 of the vehicle, degradation in antenna performance may occur in the low band (LB).

To prevent degradation in antenna performance, a slot layer 1010s may be formed in such a manner that the flexible printed circuit board 1200 is not arranged in a region where the frame 9 of the vehicle extends. The flexible printed circuit board 1200 may be arranged to extend to the film layer 1030 in such a manner as to surround a rear surface and a lateral surface of the second glass pane 1010b. The second glass substrate 1010b and the adhesive layer 1030 may be arranged to be shifted by a predetermined length in such a manner that the second glass substrate 1010b and the film layer 1030 are not arranged on the slot layer 1010s. Therefore, the slot layer 1010s on which the second substrate 1010b and the film layer 1030 are not arranged may also be referred to as an undercut region.

The flexible printed circuit board 1200 may be connected to a transparent electrode portion (indicated by a combination of 1100a and 1100b), which forms the transparent antenna module. The flexible printed circuit board 1200 and the first transparent electrode portion 1100a are connected. The second transparent electrode portion may be formed to have a different transparency than the first transparent electrode portion 1100a. A power feeding pattern may be formed on the first transparent electrode portion 1100a, and an antenna pattern may be formed on the second transparent electrode portion 1100b. The first transparent electrode portion 1100a and the second transparent electrode portion 1100b may be formed to have respective metal mesh grids that vary in line width and/or spacing.

The first transparent electrode portion 1100a may be configured to have a first transparency and a first surface resistance value. The second transparent electrode portion 1100b may be configured to have a second transparency and a second surface resistance value. The second transparent electrode portion 1100b is formed in such a manner that the second transparency thereof has a higher value than the first transparency of the first transparent electrode portion 1100a. The second transparent electrode portion 1100b is formed in such a manner that the second surface resistance value thereof is lower than the first surface resistance value of the first transparent electrode portion 1100a. Accordingly, the transparency of the second transparent electrode portion 1100b, where the antenna pattern is formed, is higher than the transparency of the first transparent electrode portion 1100a, where the power feeding pattern is formed, thereby enhancing the invisibility of the antenna pattern. In addition, the surface resistance value of the second transparent electrode portion 1100b, where the antenna pattern is formed, is lower than the surface resistance value of the first transparent electrode portion 1100a, where the power feeding pattern is formed, thereby achieving a performance improvement, such as antenna radiation efficiency.

With reference to FIGS. 6 to 8, the glass substrate module 1000 according to the present disclosure is described. As described above, the glass substrate module 1000 may be configured to include the glass substrate 1010, the transparent antenna module 1100, the controller 1400, and the connecting unit 1000CL. The glass substrate 1010 may be formed to include the multi-layer glass substrate structure in such a manner as to include the first glass substrate 1010a and the second glass substrate 1010b. The transparent antenna module 1100 may include the first antenna pattern portion 1100-1 and the second antenna pattern portion 1100-2.

The controller 1400 may be configured to control the transparent antenna module 1100. The connection portion 1000CL may be configured to electrically connect the transparent antenna module 1100 and the controller 1400. The connection portion 1000CL may constitute the flexible printed circuit board (FPCB) 1200 and a coaxial cable 610. The first antenna pattern portion 1100-1 and the second antenna pattern portion 1100-2 may be included in the transparent antenna module 1100.

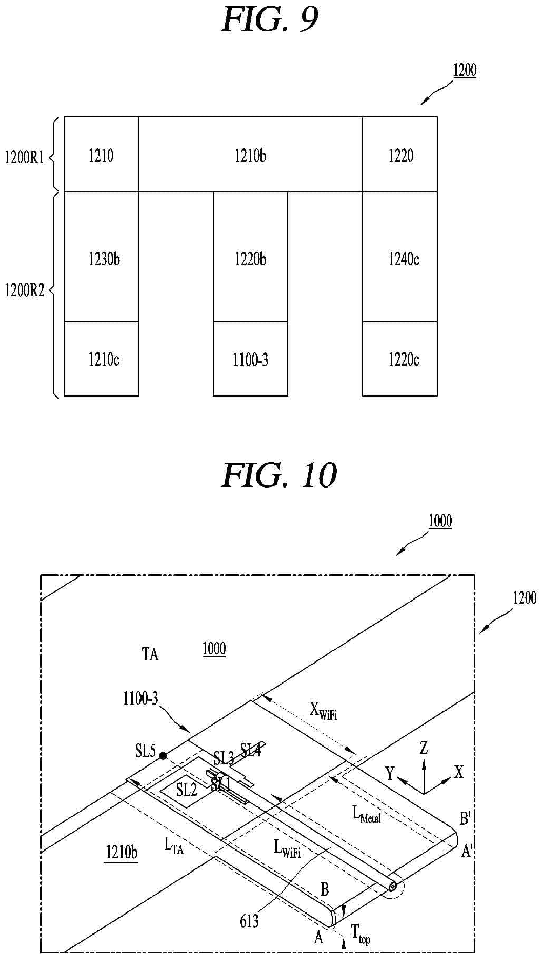

In addition, the flexible printed circuit board, on which power feeding patterns applying signals to the transparent antenna module according to the present disclosure are formed, may be divided into a plurality of regions and thus may be arranged in a bent state. In this regard, FIG. 9 is a view illustrating a state in which the flexible printed circuit board illustrated in FIGS. 6 and 7 is partitioned on a per-region basis.

With reference to FIGS. 6 to 9, the flexible printed circuit board 1200 may be formed to have a first region 1200R1 and a second region 1200R2. The first region 1200R1 may be positioned between the first glass substrate 1010a and the second glass substrate 1010b. The second region 1200R2 may be positioned outside any one of the first and second glass substrates 1010a and 1010b.

A segment of the first region 1200R1 may be electrically connected to the transparent antenna module 1100. A segment of the second region 1200R2 may be electrically connected to the coaxial cable 610. A third antenna pattern portion 1100-3 may be formed in another segment of the second region 1200R2.

The first and second antenna pattern portions 1100-1 and 1100-2 to be arranged in a transparent antenna region TA may be configured to radiate signals in frequency bands for 4G or 5G wireless communication. In this regard, the first and second antenna pattern portions 1100-1 and 1100-2 each may be configured to radiate signals in a low band (LB), a middle band (MB), a high band (HB), and an ultra-high band (UHB). The first and second antenna pattern portions 1100-1 and 1100-2 may radiate signals in a first frequency band of 617 to 960 MHz. The first and second antenna pattern portions 1100-1 and 1100-2 may radiate signals in a second frequency band of 1520 to 4500 MHz. The first and second antenna pattern portions 1100-1 and 1100-2 may radiate signals in a second frequency band of 4500 to 6000 MHz.

The third antenna pattern portion 1100-3 may be configured to radiate signals in a Wi-Fi frequency band. The third antenna pattern portion 1100-3 may be configured to radiate signals in frequency bands of 2.4 GHz, 5 GHz, and 7 GHz. The third antenna pattern portion 1100-3 forms an almost omnidirectional radiation pattern in an operational frequency band, thereby preventing distortion of a beam pattern. However, the first and second antenna pattern portions 1100-1 and 1100-2, when arranged on the glass substrate 1010, may distort the beam pattern on the third antenna pattern portion 1100-3. This is because the operation of the third antenna pattern 1100-3 at 2.4 GHz causes interference with the operations of the first and second antenna patterns 1100-1 and 1100-2 in the second operational frequency band.

In this regard, the third antenna pattern portion 1100-3 is arranged on the same layer as the transparent antenna module 1100 on a FPCB having an on-glass structure, the FPCB being integrally formed with the transparent antenna module 1100. Accordingly, at 2.4 GHz in a frequency band having a long wavelength, among the operational frequency bands, the third antenna pattern portion 1100-3 is subject to interference by a transparent electrode of the transparent antenna module 1100.

A radiation pattern formed through the third antenna pattern portion 1100-3 may be reflected by first and fourth conductive patterns 1110 and 1140, which are arranged adjacent to the third antenna pattern portion 1100-3 in the transparent antenna region TA. The radiation pattern formed through the third antenna pattern portion 1100-3 may be reflected by the first and fourth conductive patterns 1110 and 1140, thereby distorting in the shape of a beam. Therefore, the end of the third antenna pattern portion 1100-3 and the end of each of the first and fourth conductive patterns 1110 and 1140 are required to be separated by a sufficient distance to reduce the distortion in the shape of a beam. For example, the end of the third antenna pattern portion 1100-3 and the end of each of the first and fourth conductive patterns 1110 and 1140 are required to be separated by a distance of more than 0.5 times an operational wavelength. 0.5 times the wavelength at 2.4 GHz corresponds to approximately 4.5 mm.

Therefore, a position at which the third antenna pattern portion 1100-3 is arranged may be moved in the XY-axis direction or may be arranged on another layer in the Z-axis direction to reduce the beam pattern distortion phenomenon of the third antenna pattern portion 1100-3. In this regard, FIG. 10 is a view illustrating a structure in which the flexible printed circuit board, on which the third antenna pattern is formed, is bent.

With reference to FIG. 10, the glass substrate module 1000 includes the transparent antenna region TA in which the transparent antenna module may be arranged, and the flexible printed circuit board 1200. The third antenna pattern portion 1100-3 operating in a Wi-Fi frequency band may be implemented as a slot antenna in which slot patterns 1100s are formed in a ground region along a first axial direction and a second axial direction. Signals may be applied to a point on the slot patterns 1100s through an inner conductor of a third coaxial cable 613, thereby radiating the signals in the Wi-Fi frequency band.

The slot patterns 1100s may be configured to include a plurality of slot portions. The slot patterns 1100s may be configured to include first to fourth slot portions SL1, SL2, SL3, and SL4. Signals may be applied to one point on a signal line SL through the internal conductor of the third coaxial cable 613. The signal line SL may be arranged in such a manner that the third coaxial cable 613 is joined to the flexible circuit board 1200. The first slot portion SL1 and the second slot portion SL2 may be formed on one side and the other side, respectively, of the signal line SL. A first width of the first slot portion SL1 formed in a lower end portion of the signal line SL is smaller than a second width of the first slot portion SL1 formed on one side of the signal line SL.

The first slot portion SL1 may be connected to the second slot portion SL2 at a first point on one side thereof. The third slot portion SL3 may be connected to the second slot portion SL2 at a second point on the other side thereof, such that the third slot portion SL3 extends by a predetermined length in the X-axis direction. The fourth slot portion SL4 may be connected to an upper end of the second slot portion SL2 such that the fourth slot portion SL4 extends by a predetermined length in the X-axis direction. The fourth slot portion SL4 may be formed in a manner that extends in the opposite direction to the third slot portion SL3.

One end and the other end of a region in which the third antenna pattern portion 1100-3 is formed are required to be positioned within a region in which a first connection board portion 1210b of the flexible printed circuit board 1200 is formed. A length in the Y-axis direction from the end of the transparent antenna region to one end of the region in which the third antenna pattern portion 1100-3 is formed is designated as $L_{WIFI}$. A length from one end of the first connection board portion 1210b to the end of the transparent antenna region TA corresponding to the other end of the region in which the third antenna pattern portion 1100-3 is formed is designated as $L_{TA}$. A lateral surface height of the flexible printed circuit board 1200 is designated to as $T_{top}$. A distance from the end of the glass substrate 1010 to the frame of the vehicle is designated as $L_{metal}$.

When a length LTA satisfies the following Equation 1, one end and the other end of the region in which the third antenna pattern portion 1100-3 is formed are positioned within the region in which the first connection board portion 1210b of the flexible printed circuit board 1200 is formed.

## Equation 1

$$L_{TA} + T_T + L_{Metal} \leq L_{WIFI} < L_{TA} + Ttop - x_{WIFI}$$

With reference to FIGS. 6 to 8 and FIG. 10, the flexible printed circuit board 1200 may be formed to be bent along a lateral surface of any one of the first and second glass substrates 1010a and 1010b. The flexible printed circuit board 1200 may be formed in a manner that is bent along line AA'. The flexible printed circuit board 1200 may be formed in a manner that is bent along line BB'. When the flexible printed circuit board 1200 is formed to have a bent structure with a predetermined height, the third antenna pattern portion 1100-3 is formed on a different layer in the Z-axis direction than the first and second antenna pattern portions 1100-1, 1100-2 of the transparent antenna module, thereby enabling a reduction in mutual interference.

A distance $W_{WIFI}$ from the end of the region in which the third antenna pattern portion 1100-3 is formed to each of the ends of first and second antenna connection portions 1210 and 1220 is within a predetermined spacing range, thereby enabling the reduction in mutual interference and miniaturization of the transparent antenna module. In this regard, the distance $W_{WIFI}$ from the end of the region where the third antenna pattern portion 1100-3 is formed to the end of each of the first and second antenna connection portions 1210 and 1220 may be defined according to the following Equation 2.

## Equation 2

$$\lambda_{dist} < W_{WIFI} \leq W_{btw}/2$$

The distance $W_{WIFI}$ is required to be equal to or greater than a distance corresponding to a required isolation level ($\lambda_{dist}$) between each of the first and second antenna patterns 1100-1 and 1100-2 and the third antenna pattern 1100-3. Therefore, the reduction in mutual interference between each of the first and second antenna pattern portions 1100-1 and 1100-2 and the third antenna pattern portion 1100-3 is possible. The distance $W_{WIFI}$ is required to be equal to or smaller than half of the distance between the central points of the first and second antenna pattern portions 1100-1 and 1100-2. Therefore, the distance between the first and second antenna patterns 1100-1 and 1100-2, and the magnitude of the third antenna pattern portion 1100-3, are designed to be equal to or smaller than predetermined dimensions, thereby enabling miniaturization of the antenna module.

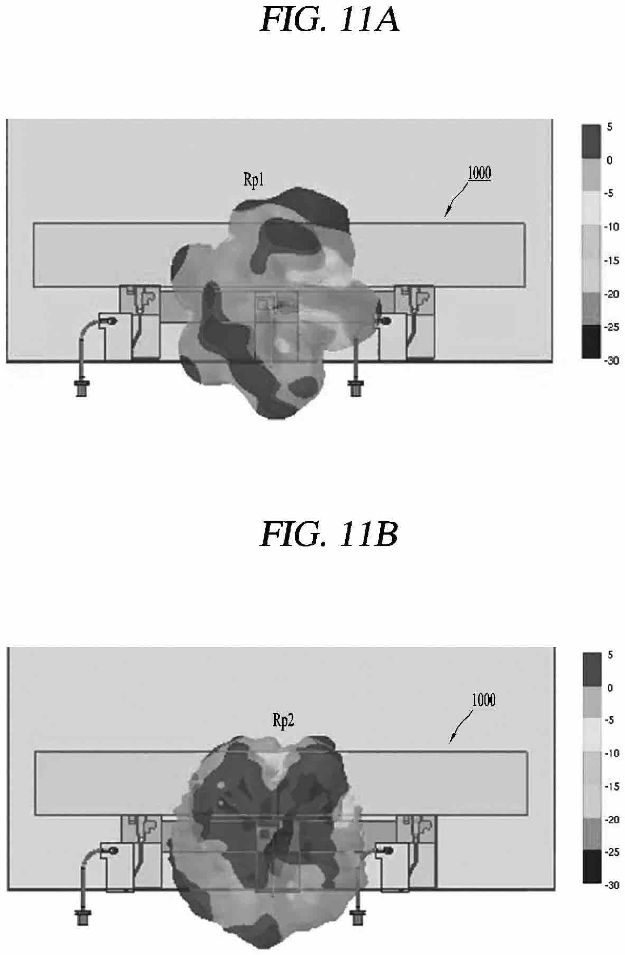

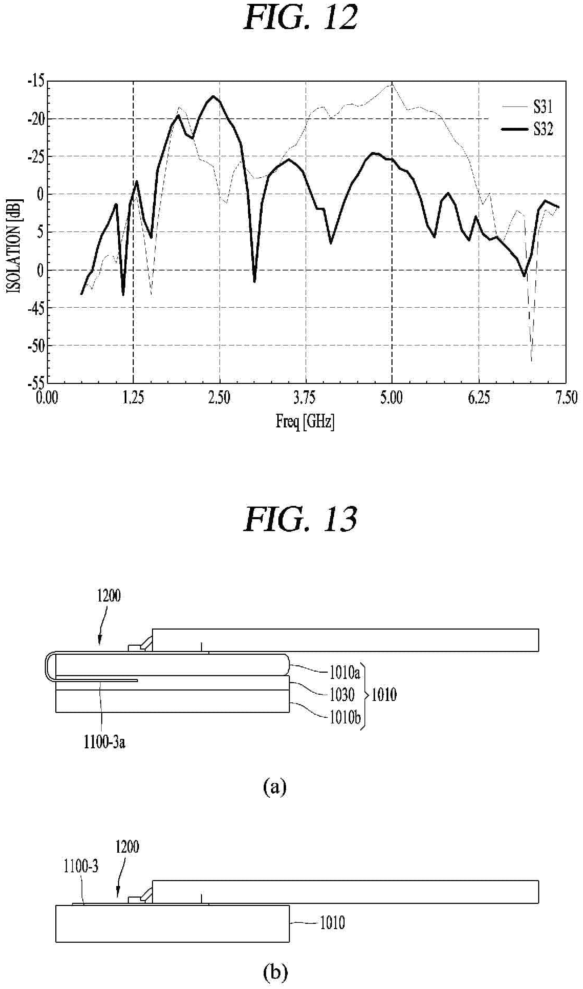

For example, a length $L_{TA}$ to one end of the region in which the third antenna pattern portion 1100-3 is formed may be set to 82.7355 mm. The distance $W_{WIFI}$ from the end of the region in which the third antenna pattern region 1100-3 is formed to the end of each of the first and second antenna connection portions 1210 and 1220 may be set to 52.5625. In this regard, FIGS. 11A and 11B are views showing, at 2.4 GHz and 5.7 GHz, respectively, a radiation of the third antenna pattern portion designed to have a bent FPCB structure. FIG. 12 is a graph showing the extent of isolation between each of the first and second antenna pattern portions and the third antenna pattern portion.

With reference to FIG. 11A, a radiation pattern Rp1 of the third antenna pattern portion undergoes almost no beam distortion phenomenon at 2.4 GHz. With reference to FIGS. 6 and 11A, a maximum value of the radiation pattern Rp1 of the third antenna pattern portion is oriented almost in the Y-axis direction. In addition, the magnitude of the radiation pattern Rp1 of the third antenna pattern portion 100-3 has a value equal to or lower than a threshold value in the X-axis direction. Accordingly, it is determined that mutual interference between the third antenna pattern portion 1100-3 and each of the first antenna pattern portions 1100-1 and 1100-2 is reduced.

With reference to FIG. 11B, a radiation pattern Rp2 of the third antenna pattern portion undergoes almost no beam distortion phenomenon at 5.7GHz. With reference to FIG. 6 and FIG. 11b, the maximum value of the radiation pattern Rp2 in the third antenna pattern portion 1100-3 is formed almost in the Y-axis direction.

In addition, the magnitude of the radiation pattern Rp2 of the third antenna pattern portion 1100-3 has a value equal to or lower than the threshold value in the X-axis direction. Accordingly, it is determined that the mutual interference between the third antenna pattern portion 1100-3 and each of the first antenna pattern portions 1100-1 and 1100-2 is reduced.

With reference to FIGS. 6 and 12, mutual interference S31 between the first antenna pattern portion 1100-1 and the third antenna pattern portion 1100-3 has a value of -15dB or less in the entire frequency band. Therefore, it is determined that the mutual interference S31 between the first antenna pattern portion 1100-1 and the third antenna pattern portion 1100-3 is reduced. Mutual interference S32 between the second antenna pattern portion 1100-2 and the third antenna pattern portion 1100-3 has a value of -15dB or less in the entire frequency band. Therefore, it is determined that the mutual interference S32 between the second antenna pattern portion 1100-2 and the third antenna pattern portion 1100-3 is reduced.

The flexible printed circuit board 1200 may be partitioned into a plurality of regions. The flexible printed circuit board 1200 may be configured to include a plurality of antenna connection portions and a plurality of connection board portions. With reference to FIGS. 6 to 10, the structure and interconnection layout of the flexible printed circuit board 1200, which is partitioned into a plurality of regions, are described in detail.

The first region 1200R1 of the flexible printed circuit board 1200 may include the first antenna connection portion 1210 and the second antenna connection portion 1220. The first antenna connection portion 1210 may be electrically connected to the first antenna pattern portion 1100-1. The second antenna connection portion 1220 may be electrically connected to the second antenna pattern portion 1100-2.

The first connection board portion 1210b may be formed on the flexible printed circuit board 1200. A second connection board portion 1220b may be further formed on the flexible printed circuit board 1200. The first connection board portion 1210b may be configured to non-electrically connect the first antenna connection portion 1210 and the second antenna connection portion 1220. The first connection board portion 1210b is arranged between the first antenna connection portion 1210 and the second antenna connection portion 1220. The conductive patterns of the first connection board portion 1210b may be configured not to be directly connected to the conductive patterns of the first antenna connection portion 1210. The conductive patterns of the first connection board portion 1210b may be configured not to be directly connected to the conductive patterns of the first antenna connection portion 1210.

The second connection board portion 1220b may be configured to non-electrically connect the first connection board portion 1210b and third antenna pattern portion 1100-3. The second connection board portion 1220b is arranged between the first connection board portion 1210b and the third antenna pattern portion 1100-3. The conductive patterns of the second board connection portion 1220b may be configured not to be directly connected to the conductive patterns of the first board connection portion 1210b. The conductive patterns of the second connection board portion 1220b may be configured not to be directly connected to the conductive patterns of the third antenna pattern portion 1100-3.

The third antenna pattern portion 1100-3 may be arranged outside any one of the first and second glass substrates 1010a and 1010b and be formed at a position overlapping the first connection board portion 1210b. The flexible printed circuit board 1200 on which the third antenna pattern portion 1100-3 is formed may be configured to be folded. The lower end portion of the third antenna pattern portion 1100-3 may be arranged in an internal region of the first connection board portion 1210b.

The coaxial cable 610, constituting the glass substrate module 1000, may include first to third coaxial cables 611, 612, and 613 connected to the first to third antenna pattern portions 1100-1, 1100-2, and 1100-3, respectively. The third coaxial cable 613 may be connected to the third antenna pattern portion 1100-3 operating in the Wi-Fi frequency band. The third antenna pattern portion 1100-3 may include a soldering region SL for connection to the third coaxial cable 613. A power feeding line and a ground line of the third coaxial cable 613 may each be electrically connected to the soldering region SL. The power feeding line and the ground line of the third coaxial cable 613 may be electrically connected to first and second soldering regions formed as metal lines, respectively.

As described above, the coaxial cables 610 may include the first coaxial cable 611 and the second coaxial cable 612 that are connected to the first and second pattern portions 1100-1 and 1100-2, respectively. The second region 1200R2 of the flexible printed circuit board 1200 may include a first cable connection portion 1210c and a second cable connection portion 1220c. The first cable connection portion 1210c may be electrically connected to the first coaxial cable 611. The second cable connection portion 1220c may be electrically connected to the second coaxial cable 612.

The flexible printed circuit board 1200 may further include a third connection board portion 1230b and a fourth connection board portion 1240b. The third connection board portion 1230b may electrically connect the first antenna connection portion 1210 and the first cable connection portion 1210c. The fourth connection board portion 1240b may electrically connect the second antenna connection portion 1220 and the second cable connection portion 1220c.

The first cable connection portion 1210c may be arranged outside any one of the first and second glass substrates 1010a and 1010b. The first cable connection portion 1210c, along with the first antenna connection portion 1210, may be arranged in a non-overlapping region. The second cable connection portion 1220c may be arranged outside the other one of the first and second glass substrates 1010a and 1010b. The second cable connection portion 1220c, along with the second antenna connection portion 1220, may be arranged in the non-overlapping region

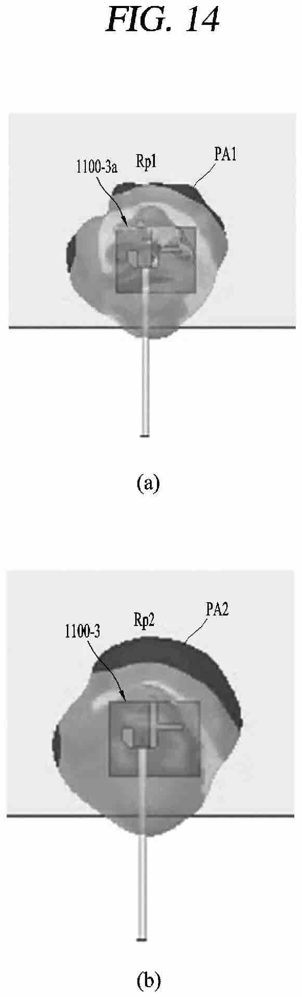

A Wi-Fi antenna according to the present disclosure may be formed to have an on-glass structure arranged on the flexible printed circuit board (FPCB) 1200 or on the glass substrate 1010. In this regard, FIG. 13 is a set of cross-sectional views that includes a cross-sectional view illustrating the Wi-Fi antenna formed on the glass substrate and a cross-sectional view illustrating the Wi-Fi antenna formed on the flexible printed circuit board, respectively. FIG. 14 is a set of views that includes a view illustrating a radiation pattern of the Wi-Fi antenna formed on the glass substrate and a view illustrating a radiation pattern of the Wi-Fi antenna formed on the flexible printed circuit board for comparison.

With reference to FIG. 8 and (a) of FIG. 13, the first and second glass substrates 1010a and 1010b exhibit a permittivity of 6.5, and the film layer 1030 between the first and second glass substrates 1010a and 1010b exhibits a permittivity of 3.2. With reference to FIG. 8, (a) of FIG. 13, and (a) of FIG. 14, a peak region PA1 of the radiation pattern RP1 of the third antenna pattern 1100-3a, implemented as the transparent electrode portion (indicated by a combination of 1100a and 1100b) inside the glass substrate 1010, is formed in a restricted region. The third antenna pattern 1100-3a, having an in-glass structure, may be formed between the first glass and second glass substrates 1010a and 1010b. The third antenna pattern 1100-3a, formed to have the in-glass structure, exhibits a permittivity of 6.5, consequently resulting in a decrease in antenna efficiency.

With reference to FIG. 8 and (b) of FIG. 13, the flexible printed circuit board 1200 exhibits a lower permittivity than the first and second glass substrates 1010a and 1010b. The flexible printed circuit board 1200, having an on-glass structure arranged on the glass substrate 1010, exhibits an effective permittivity of 4.4 to 5.2. The glass substrate 1010 in (b) of FIG. 13 may be configured to the first and second glass substrates 1010a and 1010b in (a) of FIG. 13 and the film layer 1030.

With reference to FIG. 8, (b) of FIG. 13, and (b) of FIG. 14, a peak region PA2 of the radiation pattern RP2 of the third antenna pattern 1100-3 arranged on the glass substrate 1010 is formed in a wide region. The third antenna pattern 1100-3a, formed to have the on-glass structure, exhibits an effective permittivity of 4.8, thereby increasing antenna efficiency.

The flexible printed circuit board 1200 may be configured to include a plurality of power feeding patterns and a plurality of ground patterns. The flexible printed circuit board 1200 may be formed of a plurality of layers.

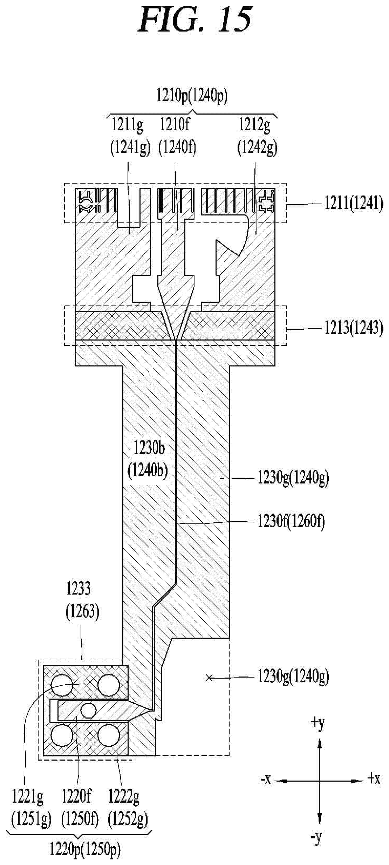

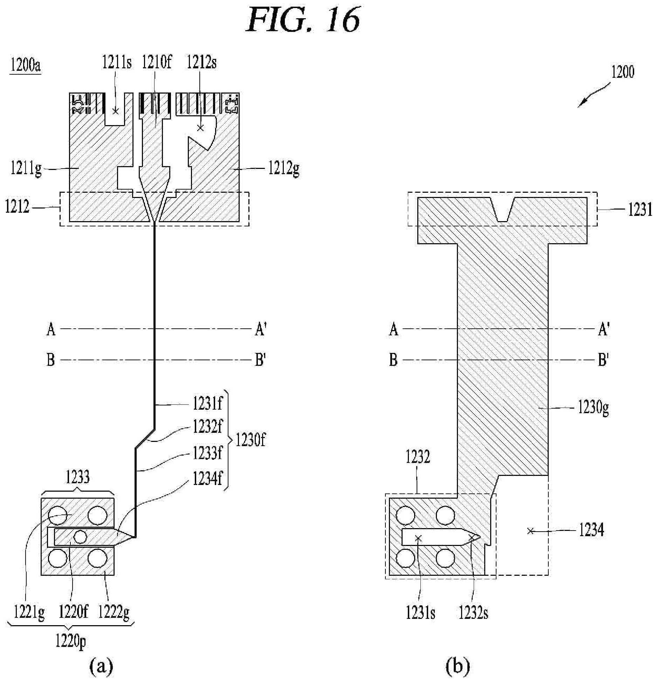

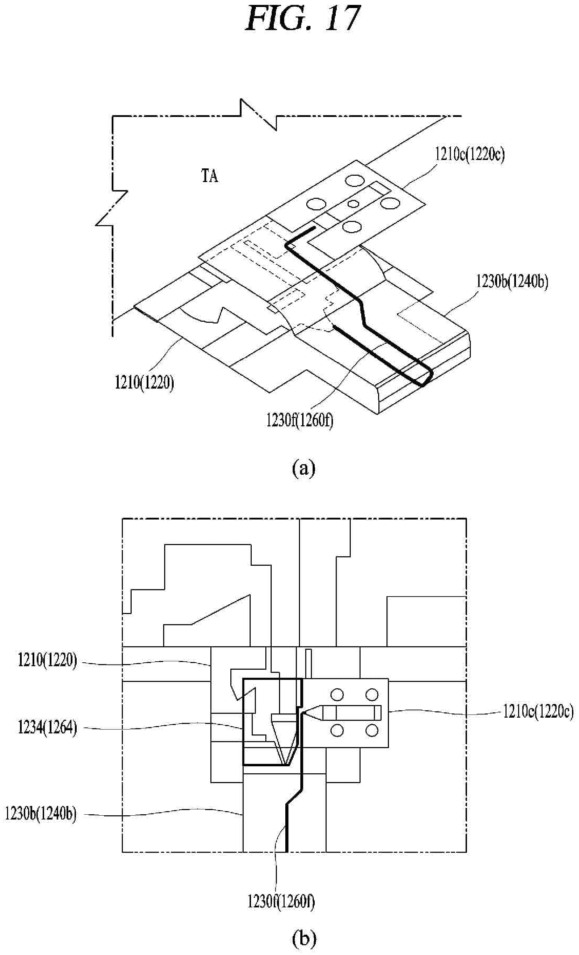

The flexible printed circuit board of the glass substrate module according to the present disclosure may be formed in a bent and folded structure. In this regard, FIGS. 15 and 16 are views illustrating the flexible printed circuit board on which the power feeding patterns electrically exciting the transparent antenna module according to the present disclosure are formed. (a) FIG. 16 illustrates a conductive pattern (power feeding pattern) formed on a first layer 1200a of the flexible circuit board 1200. FIG. 16(b) illustrates a conductive pattern (ground pattern) formed on a second layer 1200b of the flexible circuit board 1200. FIG. 17 is a set of views that includes a perspective view illustrating a structure in which the flexible circuit board, as illustrated in FIGS. 15 and 16, is assembled to the transparent antenna module, and a front view illustrating the structure.

With reference to FIGS. 15 to 17, the flexible printed circuit board of the glass substrate module according to the present disclosure is described. The flexible printed circuit boards in FIGS. 15 to 17 may include power feeding patterns 1210f and 1240f that apply signals to the first and second antenna pattern portions 1100-1 and 1100-2 in FIG. 7, respectively.

With reference to FIG. 7, and FIGS. 15 to 17, one end 1211 of a first CPW pattern 1210p of the first layer 1200a may be connected to the first antenna pattern portion 1100-1. In this regard, the first CPW pattern 1210p is not limited to being connected to the first antenna pattern portion 1100-1. A fourth CPW pattern 1240p may be connected to the second antenna pattern 1100-2. For the convenience of description, a structure in which the first CPW pattern 1210p is connected to the first antenna pattern portion 1100-1.

The first CPW pattern 1210p may be connected to the first antenna pattern portion 1100-1 by applying a low-temperature bonding technique. One end of the first power feeding pattern 1210f of the first CPW pattern 1210p may be connected to one end of the first conductive pattern 1110 of the first antenna pattern portion 1100-1. One end of each of the first ground patterns 1211g and 1212g of the first power feeding pattern 1210f may be connected to one end of each of the second conductive pattern 1120 and the third conductive pattern 1130 of the first antenna pattern portion 1100-1.

The first power feeding pattern 1210f may include at least one slit pattern. The slit pattern may refer to a pattern formed by recessing one portion of the edge of the ground pattern inward. The larger the area of the slit pattern becomes, the smaller the area of the ground pattern becomes. The slit pattern may be formed at a predetermined position to have a predetermined shape in order to increase the antenna efficiency.

The first power feeding pattern 1210f may include a first slit pattern 1211s formed by recessing one portion of the edge of the first ground unit 1211g inward. The first slit pattern 1211s may be formed by recessing, along the Y-axis direction, one portion of the edge of the first ground pattern 1211g adjacent to the first antenna pattern portion 1100-1. The first slit pattern 1211s may be formed in a rectangular shape.

The first power feeding pattern 1210f may include a second slit pattern 1212s formed by recessing one portion of the edge of the first ground pattern 1212g inward. The second slit pattern 1212s may be formed by recessing one portion of the edge adjacent to the first power feeding pattern 1210f along the X-axis direction. The second slit pattern 1212s may be configured in a sector shape.

The respective other end portions 1212 of the first ground patterns 1211g and 1212g of the first CPW pattern 1210p may overlap, in a predetermined region 1213, one end portion 1231 of a third ground pattern 1230g of the second layer 1200b. The respective other ends 1212 of the first ground patterns 1211g and 1212g may be electrically connected to one end 1231 of the third ground pattern 1230g through at least one via.

Second ground patterns 1221g and 1222g of a second CPW pattern 1220p of the first layer 1200a may overlap, in a predetermined region 1233, the other end portion 1232 of the third ground pattern 1230g of the second layer 1200b. The other portion 1232 of the third ground pattern 1230g may be formed in a shape corresponding to the second ground patterns 1221g and 1222g. A first slot 1231s from which a pattern is removed may be formed in the other end portion 1232 of the third ground pattern 1230g in a manner that corresponds to the shape of a second power feeding pattern 1220f of the second CPW pattern 1220p. The area of the first slot 1231s may be equal to or larger than the area of the second power feeding pattern 1220f.

A third power feeding pattern 1230f of the first layer 1200a may be formed in the shape of a microstrip line or CPW pattern. In a case where the third power feeding pattern 1230f is formed in the shape of the CPW pattern, ground patterns may be arranged on both sides of the third power feeding pattern 1230f. One end of the third power feeding pattern 1230f may be connected to the first power feeding pattern 1210f of the first CPW pattern 1210p. The other end of the third power feeding pattern 1230f may be connected to the second power feeding pattern 1220f of the second CPW pattern 1220p.

The third power feeding pattern 1230f may include a first line portion 1231f, a second line portion 1232f, a third line portion 1233f, and/or an end portion 1234f. An end portion 1234f of the third power feeding pattern 1230f may correspond to the other end portion of the third power feeding pattern 1230f.

A second slot 1232s from which a pattern is removed may be formed in the other end portion 1232 of the third ground pattern 1230g in a manner that corresponds to the shape of the end portion 1234f of the third power feeding pattern 1230f. The area of the second slot 1232s may be equal to or larger than the area of the end portion 1234f of the third power feeding pattern 1230f.

The flexible printed circuit board 1200 may be formed to have a bent structure. The flexible printed circuit board 1200 may be formed to have a bent structure in the third connection board portion 1230b, on which the third ground pattern 1230g and the third power feeding pattern 1230f are formed. The flexible printed circuit board 1200 may be formed to have a structure bent along Line AA' and Line BB'

On the flexible printed circuit board 1200, the first cable connection portion 1210c on which the second CPW pattern 1220p is formed may overlap the first antenna connection portion 1210 on which the first CPW pattern 1210p is formed. An overlapping region 1234 may be formed in such a manner that the ground pattern is removed therefrom, in order for the ground pattern not to be arranged on an upper region of the first feeding power pattern 1210f of the first CPW pattern 1210p. The third ground pattern 1230g of the second layer 1220b does not overlap the first power feeding pattern 1210f, thereby preventing a decrease in radiation performance of an antenna operating in a broad band and enhancing antenna efficiency.

The first line portion 1231f of the third power feeding pattern 1231f may extend from one end of the third power feeding pattern 1230f along the Y-axis direction by a length that provides a clearance gap from the overlapping region 1234. The second line portion 1232f may extend from the end of the first line portion 1231f at a predetermined angle in the X-axis direction to provide a clearance gap from the overlapping region 1234. The third line portion 1233f may extend, along the Y-axis direction, from the end of the second line portion 1232f by a length corresponding to a position of the second power feeding pattern 1220f of the second CPW pattern 1220p. The end of the third line portion 1233f may be connected to the end portion 1234f of the third power feeding pattern 1230f.

With reference to FIGS. 6 to 17, the flexible printed circuit board 1200 may be configured to include power feeding patterns on a plurality of regions, respectively, formed thereon. In this regard, the flexible printed circuit board 1200 may include the first to third power feeding patterns 1210f, 1220f, 1230f. Furthermore, the flexible printed circuit board 1200 may include the first ground patterns 1211g and 1212g, the second ground patterns 1221g and 1222g, and the third ground pattern 1230g. The first antenna connection portion 1210 of the flexible printed circuit board 1200 may include the first power feeding pattern 1210f and a plurality of the first ground patterns, for example, the first ground patterns 1211g and 1212g. The first power feeding pattern 1210f may be arranged on the first layer among the plurality of layers. The plurality of first ground patterns, for example, the first ground patterns 1211g and 1212g, may be arranged on both sides, respectively, of the first power feeding pattern 1210f. Accordingly, the first power feeding pattern 1210f and the plurality of the first ground patterns, for example, the first ground patterns 1211g and 1212g, may be formed to have a co-planar waveguide structure (CPW).

The first cable connection portion 1210c of the flexible printed circuit board 1200 may include the second power feeding pattern 1220f and the plurality of the second ground patterns, for example, the second ground patterns 1221g and 1222g. The second power feeding pattern 1220f may be arranged on the first layer among the plurality of layers. The plurality of the second ground patterns, for example, the second ground patterns 1221g and 1222g, may be arranged on both sides, respectively, of the second power feeding pattern 1220f. Accordingly, the second power feeding pattern 1220f and the plurality of the second ground patterns, for example, the second ground patterns 1221g and 1222g, may form the CPW structure.

The third connection board portion 1230b of the flexible printed circuit board 1200 may include the third power feeding pattern 1230f and the third ground pattern 1230g. The third power feeding pattern 1230f may be arranged on the first layer adjacent to a side surface of the second glass substrate 1010b among the plurality of layers. The third ground pattern 1230g may be arranged on the second layer among the plurality of layers. Both ends of the third ground pattern 1230g may be electrically connected to the first ground patterns 1211g and 1212g and the second ground patterns 1221g and 1222g, respectively, which are arranged on the first layer.

The flexible printed circuit board 1200 may further include fourth to sixth power feeding patterns 1240f, 1250f, and 1260f. Furthermore, the flexible printed circuit board 1200 may further include fourth ground patterns 1241g and 1242g, fifth ground patterns 1251g and 1252g, and a sixth ground pattern 1260g. The second antenna connection portion 1220 of the flexible printed circuit board 1200 may include the fourth power feeding pattern 1240f and a plurality of the fourth ground patterns, for example, the fourth ground patterns 1241g and 1242g. The fourth power feeding pattern 1240f may be arranged on the first layer among the plurality of layers. The plurality of the fourth ground patterns, for example, the fourth ground patterns 1241g and 1242g, may be arranged on both sides, respectively, of the fourth power feeding pattern 1240f. Accordingly, the 4-fourth power feeding pattern 1240f and the plurality of the fourth ground patterns, for example, the fourth ground patterns 1241g and 1242g, may be formed to have the CPW structure.

The second cable connection portion 1220b of the flexible printed circuit board 1200 may include a fifth power feeding pattern 1250f and a plurality of the fifth ground patterns, for example, the fifth ground patterns 1251g and 1252g. The fifth power feeding pattern 1250f may be arranged on the first layer among the plurality of layers. The plurality of the fifth ground patterns, for example, the fifth ground patterns 1251g and 1252g, may be arranged on both sides, respectively, of the fifth power feeding pattern 1250f. Accordingly, the fifth power feeding pattern 1250f and the plurality of the fifth ground patterns, for example, the fifth ground patterns 1251g and 1252g may be formed to have the CPW structure.

The fourth connection board portion 1240b of the flexible printed circuit board 1200 may include the sixth power feeding pattern 1260f and the sixth ground pattern 1260g. The sixth power feeding pattern 1260f may be arranged on the first layer adjacent to the side surface of the second glass substrate 1010b among the plurality of layers. The sixth ground pattern 1260g may be arranged on the second layer among the plurality of layers. Both ends of the sixth ground pattern 1260g may be electrically connected to the fourth ground patterns 1241g and 1242g and the fifth ground patterns 1251g and 1252g, respectively, which are arranged on the first layer.

The flexible printed circuit board 1200 may form the plurality of layers. In this regard, the flexible printed circuit board 1200 may include a layer on which conductive patterns are formed, and a layer formed of a dielectric material. The plurality of layers of the flexible printed circuit board 1200 may form the first layer, the second layer, and a third layer. The first layer 1200a may form a pattern for electrical connection at the first antenna connection portion 1210, the second antenna connection portion 1220, the first cable connection portion 1210c, and the second cable connection portion 1220c. The second layer 1200b may define a pattern for forming ground. The third layer, arranged between the first and second layers 1200a and 1200b, may form a substrate formed of a dielectric material. The third antenna pattern portion 1110-3 may be arranged on the second layer.

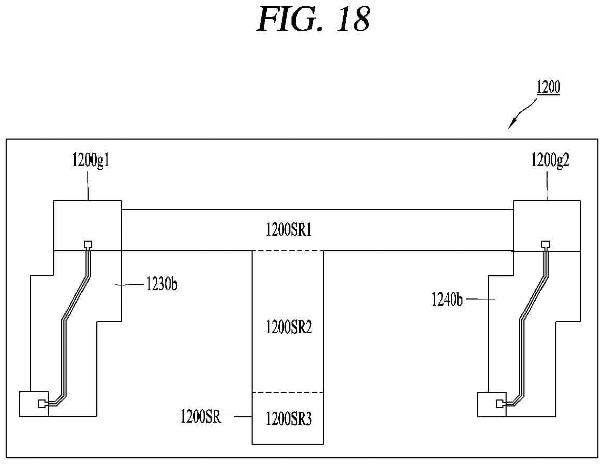

The flexible printed circuit board 1200 according to the present disclosure may be formed to have a double-sided structure. In this regard, FIG. 18 is a view illustrating a structure in which a conductive layer is removed from a region in which the Wi-Fi antenna of the flexible printed circuit board is formed to have the double-sided structure.

With reference to FIGS. 9 and 18, conductive patterns may be removed from another layer of the flexible printed circuit board 1200 in a manner that corresponds to regions that include the third antenna pattern portion 1100-3. The region from which the conductive layers are removed may form a slot region 1200SR. The slot region 1200SR may include first to third slot regions 1200SR1 and 1200SR3. The slot region 1200SR from which the conductive patterns are removed may be referred to as a fill-cut region.

First and second ground regions 1200g1 and 1200g2, corresponding to the first and second power feeding regions, may be formed on one side and the other side, respectively, of the slot region 1200SR in a manner adjacent to the slot region 1200SR. The first and second power feeding regions in which the first and second power feeding patterns may be formed on the first layer of the flexible printed circuit board 1200. The first and second ground regions 1200g1 and 1200g2 may be formed on the second layer of the flexible printed circuit board 1200 in a manner that corresponds to the first and second power-feeding regions.

Conductive patterns may be removed from another layer of the flexible printed circuit board 1200 in a manner that corresponds to the first connection board portion 1210b, the second connection board portion 1220b, and the third antenna pattern portion 1100-3. The first slot region 1200SR1 may be formed in a manner that corresponds to the first connection board portion 1210b. The second slot region 1200SR2 may be formed in a manner that corresponds to the second connection board portion 1220b. The third slot region 1200SR3 may be formed corresponding to the third antenna pattern portion 1100-3.

Accordingly, the flexible printed circuit board 1200 formed to have a double-sided FCCL structure may reduce transmission loss. The third antenna pattern portion 1100-3, implemented as the Wi-Fi antenna in the flexible printed circuit board 1200 formed to have the double-sided FCCL structure, may be formed to have a single-layer structure.

The flexible printed circuit board 1200 according to the present disclosure, which is configured to include the plurality of layer, is described in detail with reference to the drawings. With reference to FIGS. 6 to 18, the flexible printed circuit board 1200 may include the first antenna connection portion 1210, the second antenna connection portion 1220, the first cable connection portion 1210c, the second cable connection portion 1220c, and a plurality of antenna pattern portions. The plurality of antenna pattern portions may include the first antenna pattern portion 1100-1, the second antenna pattern portion 1100-2, and the third antenna pattern portion 1100-3. The flexible printed circuit board 1200 may further include a plurality of connection board portions. The flexible printed circuit board 1200 may further include the first connection board portion 1210b, the second connection board portion 1220b, the third connection board portion 1230b, and the fourth connection board portion 1240b.

The first antenna connection portion 1210 may be connected to the first antenna pattern portion 1100-1 formed on a transparent flexible substrate positioned between the first glass substrate 1010a and the second glass substrate 1010a. The second antenna connection portion 1220 may be connected to the second antenna pattern portion 1100-2 formed on the transparent flexible substrate positioned between the first glass substrate 1010a and the second glass substrate 1010a.

The first cable connection portion 1210c may be connected to the first antenna connection portion 1210 in the first region of the second glass substrate 1010b. The second cable connection portion 1220c may be connected to the second antenna connection portion 1220 in the second region of the second glass substrate 1010b. The third antenna pattern portion 1100-3 may be arranged in the second region of the second glass substrate 1010b.

The first connection board portion 1210b may be formed to non-electrically connect between the first antenna connection portion 1210 and the second antenna connection portion 1220. The second connection board portion 1220b may be formed to non-electrically connect between the first antenna connection 1210 and the third antenna pattern portion 1100-3. The third connection board portion 1230b may be formed to electrically connect the first antenna connection portion 1210 and the first cable connection portion 1210c. The fourth connection board portion 1240b may be formed to electrically connect the second antenna connection portion 1220 and the second cable connection portion 1220c.

The first cable connection portion 1210c may be arranged outside any one of the first and second glass substrates 1010a and 1010b. The first cable connection portion 1210c, along with the first antenna connection portion 1210, may be arranged in the non-overlapping region. The second cable connection portion 1220c may be arranged outside the other one of the first and second glass substrates 1010a and 1010b. The second cable connection portion 1220c, along with the second antenna connection portion 1220, may be arranged in the non-overlapping region

The flexible printed circuit board 1200 may be configured to include the power feeding patterns for each of the plurality of regions formed on the flexible printed circuit board 1200. In this regard, the flexible printed circuit board 1200 may include the first to third power feeding patterns 1210f, 1220f, 1230f. Furthermore, the flexible printed circuit board 1200 may include the first ground patterns 1211g and 1212g, the second ground patterns 1221g and 1222g, and the third ground pattern 1230g. The first antenna connection portion 1210 of the flexible printed circuit board 1200 may include the first power feeding pattern 1210f and the plurality of the first ground patterns, for example, the first ground patterns 1211g and 1212g. The first power feeding pattern 1210f may be arranged on the first layer among the plurality of layers. The plurality of first ground patterns, for example, the first ground patterns 1211g and 1212g, may be arranged on both sides, respectively, of the first power feeding pattern 1210f. Accordingly, the first power feeding pattern 1210f and the plurality of the first ground patterns, for example, the first ground patterns 1211g and 1212g, may be formed to have the co-planner waveguide structure (CPW).

The first cable connection portion 1210c of the flexible printed circuit board 1200 may include the second power feeding pattern 1220f and the plurality of the second ground patterns, for example, the second ground patterns 1221g and 1222g. The second power feeding pattern 1220f may be arranged on the first layer among the plurality of layers. The plurality of the second ground patterns, for example, the second ground patterns 1221g and 1222g, may be arranged on both sides, respectively, of the second power feeding pattern 1220f. Accordingly, the second power feeding pattern 1220f and the plurality of the second ground patterns, for example, the second ground patterns 1221g and 1222g, may form the CPW structure.

The third connection board portion 1230b of the flexible printed circuit board 1200 may include the third power feeding pattern 1230f and the third ground pattern 1230g. The third power feeding pattern 1230f may be arranged on the first layer adjacent to the side surface of the second glass substrate 1010b among the plurality of layers. The third ground pattern 1230g may be arranged on the second layer among the plurality of layers. Both ends of the third ground pattern 1230g may be electrically connected to the first ground patterns 1211g and 1212g and the second ground patterns 1221g and 1222g, respectively, which are arranged on the first layer.

The flexible printed circuit board 1200 may further include the fourth to sixth power feeding patterns 1240f, 1250f, and 1260f. Furthermore, the flexible printed circuit board 1200 may further include the fourth ground patterns 1241g and 1242g, the fifth ground patterns 1251g and 1252g, and the sixth ground pattern 1260g. The second antenna connection portion 1220 of the flexible printed circuit board 1200 may include the fourth power feeding pattern 1240f and the plurality of the fourth ground patterns, for example, the fourth ground patterns 1241g and 1242g. The fourth power feeding pattern 1240f may be arranged on the first layer among the plurality of layers. The plurality of the fourth ground patterns, for example, the fourth ground patterns 1241g and 1242g, may be arranged on both sides, respectively, of the fourth power feeding pattern 1240f. Accordingly, the 4-fourth power feeding pattern 1240f and the plurality of the fourth ground patterns, for example, the fourth ground patterns 1241g and 1242g, may be formed to have the CPW structure.

The second cable connection portion 1220b of the flexible printed circuit board 1200 may include the fifth power feeding pattern 1250f and the plurality of the fifth ground patterns, for example, the fifth ground patterns 1251g and 1252g. The fifth power feeding pattern 1250f may be arranged on the first layer among the plurality of layers. The plurality of the fifth ground patterns, for example, the fifth ground patterns 1251g and 1252g, may be arranged on both sides, respectively, of the fifth power feeding pattern 1250f. Accordingly, the fifth power feeding pattern 1250f and the plurality of the fifth ground patterns, for example, the fifth ground patterns 1251g and 1252g, may be formed to have the CPW structure.

The fourth connection board portion 1240b of the flexible printed circuit board 1200 may include the sixth power feeding pattern 1260f and the sixth ground pattern 1260g. The sixth power feeding pattern 1260f may be arranged on the first layer adjacent to the side surface of the second glass substrate 1010b among the plurality of layers. The sixth ground pattern 1260g may be arranged on the second layer among the plurality of layers. Both ends of the sixth ground pattern 1260g may be electrically connected to the fourth ground patterns 1241g and 1242g and the fifth ground patterns 1251g and 1252g, respectively, which are arranged on the first layer.

The flexible printed circuit board 1200 may form the plurality of layers. In this regard, the flexible printed circuit board 1200 may include a layer on which conductive patterns are formed, and a layer formed of a dielectric material. The plurality of layers of the flexible printed circuit board 1200 may form the first layer, the second layer, and the third layer. The first layer 1200a may form a pattern for electrical connection at the first antenna connection portion 1210, the second antenna connection portion 1220, the first cable connection portion 1210c, and the second cable connection portion 1220c. The second layer 1200b may define a pattern for forming ground. The third layer, arranged between the first and second layers 1200a and 1200b, may form a substrate formed of a dielectric material. The third antenna pattern portion 1110-3 may be arranged on the second layer.

As described above, in order to reduce transmission loss of the third antenna pattern portion 1100-3 implemented as the Wi-Fi antenna, the slot region 1200SR in which conductive patterns are removed may be formed on the flexible printed circuit board 1200. As illustrated in (b) of FIG. 8, an under-cut structure is employed in which the slot layer 1919s is formed in such a manner that the flexible printed circuit board 1200 is not arranged in a region in which the frame 9 of the vehicle extends. The under-cut structure enables the performance of the transparent antenna module in a low band (LB).

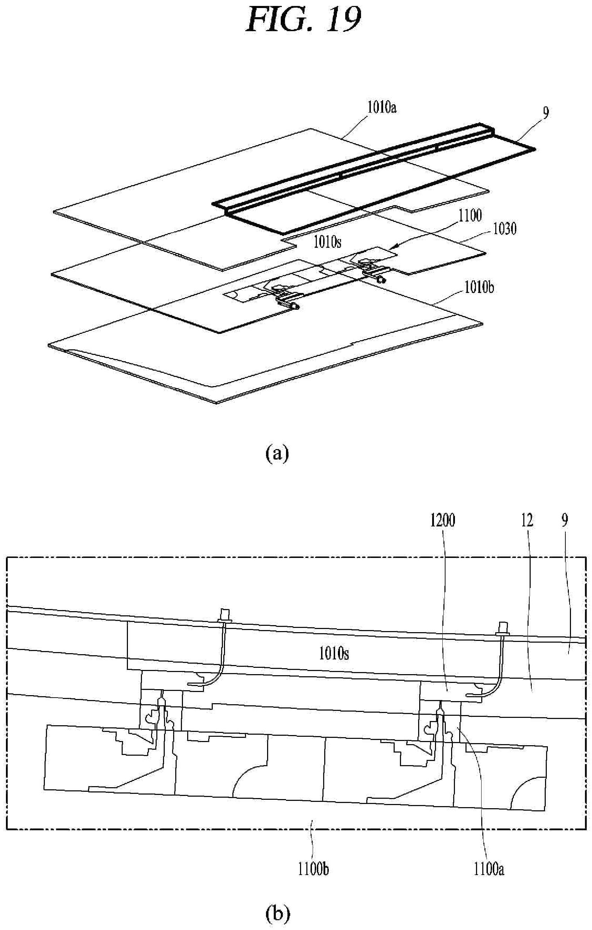

In this regard, FIG. 19 is a set of views that includes a view illustrating a stack structure in which the glass substrate, including the slot layer formed to have the under-cut structure, the transparent antenna module, and the frame of the vehicle, have not yet been assembled, and an enlarged view illustrating a structure in which the assembly is complete. (a) of FIG. 19 illustrates the stack structure before the assembly of the glass substrate module 1000. (b) of FIG. 19 illustrates an enlarged structure in which the glass substrate module 1000 is assembled with the frame 9 of the vehicle.

With reference to FIGS. 7, 8, and 19, the glass substrate 1000, having the dual-interface glass structure, includes the first glass substrate 1010a and the second glass substrate 1010b, which include the slot layer 1010s. The film layer 1030 is arranged between the first glass substrate 1010a and the second glass substrate 1010b. The transparent antenna module 1100, including the first and second antenna pattern portions 1100-1 and 1100-2, may be arranged on the film layer 1030. The first glass substrate 1010a, including the slot layers 1010s, may be coupled to the frame 9 of the vehicle. Accordingly, interference between the transparent antenna module 1100 radiating signals in a low band (LB) and the frame 9 of the vehicle is reduced, thereby improving the efficiency of the transparent antenna module 1100 in the low band (LB).

The slot layer 1010s may be formed to have a width of approximately 15 mm. The slot layer 1010s having a predetermined width may prevent degradation in antenna performance of the transparent antenna module 1100 due to interference with a groove 9g in the frame 9. The flexible printed circuit board 1200 may be arranged in the opaque region 12 of the glass substrate 10. The first and fourth power feeding patterns 1210f and 1240 may be formed on the first transparent electrode portion 1100a of the transparent antenna module 1100. The first and second power feeding patterns 1100-1 and 1100-2 may be formed on the second transparent electrode portion 1100b of the transparent antenna module 1100. The first transparent electrode part 1100a, having a predetermined length, may separate the first and second pattern portions 1100-1 and 1100-2 by a predetermined distance from the opaque region 12. Accordingly, the invisibility of the transparent antenna module 1100 may be enhanced, and the antenna efficiency may be increased.

The first transparent electrode portion 1100a may be formed to have the first transparency higher than the second transparency of the second transparent electrode portion 1100b. The first transparent electrode portion 1100a may be formed to have a first surface resistance value lower than a second surface resistance value of the second transparent electrode portion 1100b. The first transparent electrode portion 1100a may have a first surface resistance value of approximately 0.5 ohm. The second transparent electrode portion 1100a may have a second surface resistance value of approximately 0.1 ohm.

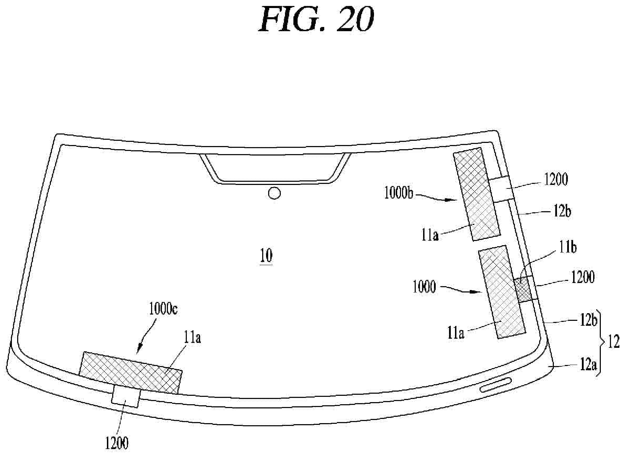

The glass substrate module 1000, including the transparent antenna module according to the present disclosure, may be arranged in a specific region of the glass substrate 1010 of the vehicle. In this regard, FIG. 20 is a view illustrating glass substrate modules that may be arranged in a plurality of regions of the glass substrate of the vehicle.

With reference to FIG. 20, the glass substrate modules 1000, 1000b, and 1000c may be arranged on the glass pane 10 of the vehicle. The glass substrate modules 1000 and 1000b may be formed on one side region or the other side region of the glass pane 10. The glass substrate module 1000c may be formed in a lower region of the glass pane 10. The glass pane 10 of the vehicle may include the transparent region 11 and the opaque region 12 formed to surround the transparent region 11. The opaque region 12 formed to surround the transparent region 11 may form a frit region.

The glass substrate module 1000 may include a first transparent electrode region 11a, a second transparent electrode region 11b, and an FPCB 1200. The second and third glass substrate modules 1000b and 1000c may include the first transparent electrode region 11a and the FPCB 1200.

The FPCB 1200 of the glass substrate module 1000 may be arranged in an opaque region 12b on one side or the other side of the glass pane 10. The FPCB 1200 of the second glass substrate module 1000b may be arranged in the opaque region 12b and the transparent region 11 on one side or the other side of the glass pane 10. The FPCB 1200 of the third glass substrate module 1000c may be disposed in an opaque region 12a on the lower side of the glass pane 10.

The second and third glass substrate modules 1000b and 1000c may include the first transparent electrode region 11a as a common layer, thereby constituting a signal transparent electrode antenna. When a single transparent electrode antenna is arranged in the opaque region 12b, which is formed narrowly like a side surface of the glass pane 10, an opaque region of the FPCB 1200 is exposed to the transparent region 11 of the glass pane 10, which is a visible region. A conductive pattern arranged on the FPCB 1200 forms an opaque region of the FPCB 1200.

The glass substrate module 1000, having the first and second transparent electrode regions 11a and 11b, is designed as a transparent electrode exhibiting heterogeneous surface resistance. When designing a transparent electrode exhibiting heterogeneous surface resistance, portions attached to the transparent region 11 of the glass pane 10, which is a visible region, are all designed as transparent electrodes. Accordingly, the flexibility of attachment to various positions on the glass pane 10 of the vehicle enhances the installation versatility and the visibility of the transparent antenna module.

In this regard, the glass substrate module 1000, implemented as the transparent electrode exhibiting heterogeneous surface resistance, may include the first transparent electrode region 11a, the second transparent electrode region 11b, and the FPCB 1200. The first transparent electrode region 11a may be formed to have a first metal mesh grid structure including metal mesh lines arranged at a first pitch apart. The second transparent electrode region 11b may be formed to have a second metal mesh grid structure including metal mesh lines arranged at a second pitch apart. The second pitch is narrower than the first pitch.

The glass substrate module, arrangeable on the glass pane of the vehicle, and the flexible printed circuit board, configured to include the plurality of layers, have been described above. The technical effects of the glass substrate module, arrangeable on the glass pane of the vehicle, and the technical effects of the flexible printed circuit board, configured to include the plurality of layers, are described as follows.

According to the present disclosure, interference between the transparent antenna, arranged in the transparent region, and the antenna, arranged in the opaque region, can be reduced in the glass substrate module on the glass pane of the vehicle.

According to the present disclosure, the Wi-Fi antenna is arranged in a specific region of the flexible printed circuit board configured to include the plurality of layers, the flexible printed circuit board being arrangeable on the glass pane of the vehicle, thereby enabling a reduction in interference between the Wi-Fi antenna and the transparent antenna.

According to the present disclosure, the formation of the flexible printed circuit board to have a bent structure can prevent distortion in the shape of a beam due to interference between the antenna formed of a film material and the transparent electrode forming the transparent antenna.

According to the present disclosure, the transparent antenna, having a transparent electrode structure exhibiting heterogeneous surface resistance, and the opaque antenna, formed of a film material, can be arranged on one side or the other side of the glass pane of the vehicle.

The further range of potential embodiments and technical applications of the present disclosure will be readily understood or evident from the foregoing detailed description of the present disclosure. However, it will be apparent to persons having ordinary skill in the art that various alterations and equivalent substitutions may be made within the technical ideas and scope of the present disclosure. Accordingly, the detailed description and specific embodiments, including preferred embodiments, are intended to be exemplary and not limiting. The scope of the present disclosure is defined by proper interpretation of the following claims. All equivalent modifications to the embodiments of the present disclosure are intended to come within the scope of the present disclosure.

**Claims**

1. A glass substrate module comprising:

> a first glass substrate;
> a second glass substrate;
> a transparent antenna module arranged between the first glass substrate and the second glass substrate;
> a control unit that controls the transparent antenna module; and
> a connection portion that electrically connects the transparent antenna and the control unit,
> wherein the transparent antenna module includes a first antenna pattern portion and a second antenna pattern portion,
> wherein the connection portion constitutes a flexible printed circuit board and coaxial cables,
> wherein the flexible printed circuit board is formed to have a first region positioned between the first glass substrate and the second glass substrate, and a second region positioned outside any one of the first and second glass substrates,
> wherein a segment of the first region is electrically connected to the transparent antenna module,
> wherein a segment of the second region is electrically connected to the coaxial cable, and
> wherein a third antenna pattern portion is formed in another segment of the second region.

2. The glass substrate module of claim 1, wherein the first region of the flexible printed circuit board includes a first antenna connection portion, electrically connected to the first antenna pattern portion, and a second antenna connection portion, electrically connected to the second antenna pattern portion, and wherein the flexible printed circuit board forms a first connection board portion that non-electrically connects the first antenna connection portion and the second antenna connection portion.

3. The glass substrate module of claim 1, wherein the flexible printed circuit board forms a second connection board portion that non-electrically connects the first connection board portion and the third antenna pattern portion, and
wherein the third antenna pattern portion is arranged outside any one of the first and second glass substrates and is formed at a position overlapping the first connection board portion.

4. The glass substrate module of claim 3, wherein the third antenna pattern portion includes a soldering region for connection to a third coaxial cable, and wherein a power feeding line and a ground line of the third coaxial cable are electrically connected to the soldering region.

5. The glass substrate module of claim 2, wherein the coaxial cables includes a first coaxial cable and a second coaxial cable,

wherein the second region of the flexible printed circuit board includes a first cable connection portion, electrically connected to the first coaxial cable, and a second cable connection portion, electrically connected to the second coaxial cable, and
wherein the flexible printed circuit board comprises:

a third connection board portion that electrically connects the first antenna connection portion and the first cable connection portion; and
a fourth connection board portion that electrically connects the second antenna connection portion and the second cable connection portion.

6. The glass substrate module of claim 5, wherein the first cable connection portion is arranged outside any one of the first and second glass substrates and, along with the first antenna connection portion, is arranged in a non-overlapping region, and
wherein the second cable connection portion is arranged outside the other one of the first and second glass substrates and, along with the second antenna connection portion, is arranged in the non-overlapping region.

7. The glass substrate module of claim 5, wherein the flexible printed circuit board forms a plurality of layers,
wherein the first antenna connection portion of the flexible printed circuit board comprises:

a first power feeding pattern arranged on a first layer among the plurality of layers; and
a plurality of first ground patterns arranged on both sides, respectively, of the first power feeding pattern,
wherein the first cable connection portion of the flexible printed circuit board comprises:

a second power feeding pattern arranged on the first layer among the plurality of layers; and
a plurality of second ground patterns arranged on both sides, respectively, of the first power feeding pattern,
wherein the third connection board portion of the flexible printed circuit board includes a third power feeding pattern, arranged in the first layer, adjacent to a side surface of the second glass substrate, and a third ground pattern, arranged on a second layer, among the plurality of layers, and
wherein both ends of the third ground pattern are electrically connected to the first ground pattern and the second ground pattern, respectively, that are arranged on the first layer.

8. The glass substrate module of claim 5, wherein the flexible printed circuit board forms a plurality of layers,
wherein the second antenna connection portion of the flexible printed circuit board comprises:

a fourth power feeding pattern arranged on a first layer among the plurality of layers; and
a plurality of fourth ground patterns arranged on both sides, respectively, of the fourth power feeding pattern,
wherein the second cable connection portion of the flexible printed circuit board comprises:

a fifth power feeding pattern arranged on the first layer among the plurality of layers; and
a plurality of fifth ground patterns arranged on both sides, respectively, of the fifth power feeding pattern,

wherein the fourth connection board portion of the flexible printed circuit board includes a sixth power feeding pattern, arranged on the first layer, adjacent to a side surface of the second glass substrate, and a sixth ground pattern, arranged on a second layer, among the plurality of layers, and

wherein both ends of the sixth ground pattern are electrically connected to the fourth ground pattern and the fifth ground pattern, respectively, that are arranged on the first layer.

9. The glass substrate module of claim 1, wherein the flexible printed circuit board forms a plurality of layers,

wherein the plurality of layers includes first, second, and third layers,
wherein the first layer forms a pattern for electrical connection at the first antenna connection portion, the second antenna connection portion, the first cable connection portion, and the second cable connection portion,
wherein the second layer forms a pattern for forming ground,
wherein a third layer arranged between the first and second layers forms a substrate formed of a dielectric material, and
wherein the third antenna pattern portion is arranged on the second layer.

10. A flexible printed circuit board configured to include a plurality of layers, the flexible printed circuit board comprising:

a first antenna connection portion and a second antenna connection portion connected to a first antenna pattern portion and a second antenna pattern portion, respectively, formed on a transparent flexible board positioned between a first glass substrate and a second glass substrate;
a first cable connection portion connected to a first antenna connection portion in a first region of the second glass substrate;
a second cable connection portion connected to a second antenna connection portion in a second region of the second glass substrate;
a third antenna pattern portion arranged in a third region of the second glass substrate;
a first connection board portion that non-electrically connects between the first antenna connection portion and the second antenna connection portion;
a second connection board portion that non-electrically connects the first antenna connection portion and the third antenna pattern portion;

a third connection board portion that electrically connects the first antenna connection portion and the first cable connection portion; and
a fourth connection board portion that electrically connects the second antenna connection portion and the second cable connection portion.

11. The flexible printed circuit board of claim 10, wherein the first cable connection portion is arranged outside any one of the first and second glass substrates and, along with the first antenna connection portion, is arranged in a non-overlapping region, and wherein the second cable connection portion is arranged outside the other one of the first and second glass substrates and, along with the second antenna connection portion, is arranged in the non-overlapping region.

12. The flexible printed circuit board of claim 10, the flexible printed circuit board forming the plurality of layers, wherein the first antenna connection portion of the flexible printed circuit board comprises:

a first power feeding pattern arranged on a first layer among the plurality of layers; and
a plurality of first ground patterns arranged on both sides, respectively, of the first power feeding pattern,
wherein the first cable connection portion of the flexible printed circuit board comprises:

a second power feeding pattern arranged on the first layer among the plurality of layers; and
a plurality of second ground patterns arranged on both sides, respectively, of the first power feeding pattern,
wherein the third connection board portion of the flexible printed circuit board includes a third power feeding pattern arranged on the first layer, adjacent to a side surface of the second glass substrate, and a third ground pattern, arranged on a second layer, among the plurality of layers, and
wherein both ends of the third ground pattern are electrically connected to the first ground pattern and the second ground pattern, respectively, that are arranged on the first layer.

13. The flexible printed circuit board of claim 12, the flexible printed circuit board forming a plurality of layers, wherein the second antenna connection portion of the flexible printed circuit board comprises:

a fourth power feeding pattern arranged on a first layer among the plurality of layers; and
a plurality of fourth ground patterns arranged on both sides, respectively, of the fourth power feeding pattern,
wherein the second cable connection portion of the flexible printed circuit board comprises:

a fifth power feeding pattern arranged on the first layer among the plurality of layers; and
a plurality of fifth ground patterns arranged on both sides,respectively, of the fifth power feeding pattern,
wherein the fourth connection board portion of the flexible printed circuit board includes a sixth power feeding pattern arranged on the first layer, adjacent to the side surface of the second glass substrate, among the plurality, and a sixth ground pattern, arranged on a second layer, and
wherein both ends of the sixth ground pattern are electrically connected to the fourth ground pattern and the fifth ground pattern, respectively, that are arranged on the first layer.

14. The flexible printed circuit board of claim 10, the flexible printed circuit board forming a plurality of layers, wherein the plurality of layers includes first, second, and third layers,

wherein the first layer forms a pattern for electrical connection at the first antenna connection portion, the second antenna connection portion, the first cable connection portion, and the second cable connection portion,
wherein the second layer forms a pattern for forming ground,
wherein a third layer arranged between the first and second layers forms a substrate formed of a dielectric material, and
wherein the third antenna pattern is arranged on the second layer.

# FIG. 1

# FIG. 2

# FIG. 3

# FIG. 4

# FIG. 5

**FIG. 6**

FIG. 7

# FIG. 8

(a)

(b)

## FIG. 9

## FIG. 10

# FIG. 11A

# FIG. 11B

## FIG. 12

## FIG. 13

(a)

(b)

# FIG. 14

(a)

(b)

# FIG. 15

# FIG. 16

(a)

(b)

EP 4 786 165 A1

# FIG. 17

(a)

(b)

# FIG. 18

# FIG. 19

1010a

9

1100

1030

1010s

1010b

(a)

1200  12  9

1010s

1100b  1100a

(b)

# FIG. 20

## INTERNATIONAL SEARCH REPORT

| | International application No. |
|---|---|
| | **PCT/KR2023/016986** |

| | |
|---|---|
| **A.** | **CLASSIFICATION OF SUBJECT MATTER** |

**B32B 17/10**(2006.01)i; **B60J 1/00**(2006.01)i; **H01Q 1/12**(2006.01)i; **H01Q 1/32**(2006.01)i; **H01Q 1/38**(2006.01)i; **H05K 1/14**(2006.01)i

According to International Patent Classification (IPC) or to both national classification and IPC

| | |
|---|---|
| **B.** | **FIELDS SEARCHED** |

Minimum documentation searched (classification system followed by classification symbols)

B32B 17/10(2006.01); H01Q 1/12(2006.01); H01Q 1/22(2006.01); H01Q 1/32(2006.01); H01Q 1/46(2006.01); H04M 1/02(2006.01); H05B 3/86(2006.01); H05K 1/02(2006.01); H05K 1/11(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유리기판(glass substrate), 투명 안테나(transparent antenna), 연성인쇄회로기판 (flexible printed circuit board)

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| A | KR 10-1998-0064404 A (PPG INDUSTRIES, INC.) 07 October 1998 (1998-10-07)<br>See claims 1, 10 and 25; paragraphs [0003]-[0015]; and figures 2-6. | 1-14 |
| A | KR 10-2021-0017097 A (SAMSUNG ELECTRONICS CO., LTD.) 17 February 2021 (2021-02-17)<br>See claim 7; and figure 3. | 1-14 |
| A | JP 2017-505576 A (AGC FLAT GLASS NORTH AMERICA, INC.) 16 February 2017 (2017-02-16)<br>See entire document. | 1-14 |
| A | US 2019-0261464 A1 (AGC AUTOMOTIVE AMERICAS R&D, INC.) 22 August 2019 (2019-08-22)<br>See entire document. | 1-14 |
| A | US 2021-0143526 A1 (TDK CORPORATION) 13 May 2021 (2021-05-13)<br>See entire document. | 1-14 |

| | | | |
|---|---|---|---|
| ☐ Further documents are listed in the continuation of Box C. | | ☑ See patent family annex. | |

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **18 July 2024** | **22 July 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2023/016986**

| Patent document cited in search report | | | Publication date (day/month/year) | Patent family member(s) | | | Publication date (day/month/year) |
|---|---|---|---|---|---|---|---|
| KR | 10-1998-0064404 | A | 07 October 1998 | CN | 100115741 | C | 23 July 2003 |
| | | | | CN | 100203463 | A | 30 December 1998 |
| | | | | EP | 0849823 | A1 | 24 June 1998 |
| | | | | JP | 10-224137 | A | 21 August 1998 |
| | | | | JP | 2004-048780 | A | 12 February 2004 |
| | | | | KR | 10-0295001 | B1 | 12 July 2001 |
| | | | | KR | 10-0335550 | B1 | 23 April 2002 |
| | | | | US | 5999134 | A | 07 December 1999 |
| KR | 10-2021-0017097 | A | 17 February 2021 | US | 2022-0159112 | A1 | 19 May 2022 |
| | | | | WO | 2021-025333 | A1 | 11 February 2021 |
| JP | 2017-505576 | A | 16 February 2017 | EP | 3097603 | A1 | 30 November 2016 |
| | | | | EP | 3097603 | B1 | 05 December 2018 |
| | | | | JP | 6123033 | B2 | 26 April 2017 |
| | | | | WO | 2015-112135 | A1 | 30 July 2015 |
| US | 2019-0261464 | A1 | 22 August 2019 | EP | 3528338 | A1 | 21 August 2019 |
| | | | | EP | 3528338 | B1 | 17 March 2021 |
| | | | | US | 10721795 | B2 | 21 July 2020 |
| US | 2021-0143526 | A1 | 13 May 2021 | CN | 112803148 | A | 14 May 2021 |
| | | | | CN | 112803148 | B | 11 April 2023 |
| | | | | JP | 2021-078077 | A | 20 May 2021 |
| | | | | JP | 6977754 | B2 | 08 December 2021 |
| | | | | US | 11374304 | B2 | 28 June 2022 |

Form PCT/ISA/210 (patent family annex) (July 2022)